# EUROPEAN PATENT SPECIFICATION

(11) **EP 4 203 071 B1**
(45) Date of publication and mention of the grant of the patent: **20.05.2026**
(21) Application number: 22201885.5
(22) Date of filing: 17.10.2022
(51) Int. Cl.: H01L 21/265, H10D 12/01, H10D 30/01, H10D 30/69, H10D 30/62, H10D 62/10

(54) **STRAIN COMPENSATION VIA ION IMPLANTATION IN RELAXED BUFFER LAYER TO PREVENT WAFER BOW**
SPANNUNGSKOMPENSATION DURCH IONENIMPLANTATION IN EINER RELAXIERTEN PUFFERSCHICHT ZUR VERHINDERUNG VON WAFERKRÜMMUNG
COMPENSATION DE CONTRAINTE PAR IMPLANTATION IONIQUE DANS UNE COUCHE TAMPON RELAXÉE POUR EMPÊCHER L'ARC DE TRANCHE

(30) Priority: 23.12.2021 US 202117560641
(43) Date of publication of application: 28.06.2023
(73) Proprietor: INTEL Corporation, Santa Clara, CA 95054 (US)
(72) Inventor: BOMBERGER, Cory C., Portland, 97225 (US); JAMBUNATHAN, Karthik, Hillsboro, 97124 (US); MURTHY, Anand, Portland, 97229 (US); NAM, Ju, Hillsboro, 97124 (US); GHANI, Tahir, Portland, 97229 (US)
(74) Representative: Goddar, Heinz J.

(56) References cited:
- EP-A1- 3 624 200
- US-A1- 2021 083 116
- US-B1- 9 570 300
- US-B2- 7 307 273

## Description

### BACKGROUND

In many integrated circuit applications, a common design goal for transistors is to increase the mobility of charge carriers in the channel. For example, with respect to PMOS transistors, it is often desirable to increase the mobility of holes in the channel, and with respect to NMOS transistors, it is often desirable increase the mobility of electrons in the channel. In some cases, charge carrier mobility may be increased by forming the channel on a layer whose properties are designed to impart strain on the channel. If the layer is too thin, however, defects from the layer may propagate into the channel, and if the layer is too thick, wafer bowing may occur during downstream fabrication processing. US 2021/083116 A1 and EP 3624200 A1 disclose an integrated circuit device comprising a buffer layer of SiGe layer above a substrate, as known in the prior art.

### BRIEF DESCRIPTION OF THE DRAWINGS

FIGS. 1A-I illustrate cross-section views of example integrated circuit structures formed on a relaxed buffer with ion implants for strain compensation during various stages of fabrication.
FIG. 2 illustrates a method of forming an integrated circuit having transistors with diverse/strained channel materials enabled by an ion-implanted relaxed buffer layer.
FIGS. 3A-D illustrate example integrated circuit structures formed when carrying out certain portions of the method of FIG. 2 using a blanket deposition approach. Note that the example structures of FIGS. 3A-D continue on to the example structures of FIGS. 4E-J.
FIGS. 4A-J illustrate example integrated circuit structures formed when carrying out the method of FIG. 2 using a replacement fin-based approach.
FIG. 5 illustrates an example cross-sectional view taken along the plane J-J in FIG. 4J.
FIG. 6 is a schematic of a transmission electron microscopy (TEM) image showing an example stack of layers with implanted ions among defects formed at a layer interface.
FIG. 7 illustrates a computing system implemented with integrated circuit structures and/or transistor devices formed using the techniques and embodiments disclosed herein.

These and other features of the present embodiments will be understood better by reading the following detailed description, taken together with the figures herein described. In the drawings, each identical or nearly identical component that is illustrated in various figures may be represented by a like numeral. For purposes of clarity, not every component may be labeled in every drawing. Furthermore, as will be appreciated, the figures are not necessarily drawn to scale or intended to limit the described embodiments to the specific configurations shown. For instance, while some figures generally indicate straight lines, right angles, and smooth surfaces, an actual implementation of the disclosed techniques may have less than perfect straight lines and right angles, and some features may have surface topography or otherwise be non-smooth, given real-world limitations of fabrication processes. Further still, some of the features in the drawings may include a patterned and/or shaded fill, which is merely provided to assist in visually identifying the different features. In short, the figures are provided merely to show example structures.

### DETAILED DESCRIPTION

The subject matter of the present invention is defined in claim 1. In the context of transistors, for many integrated circuit (IC) applications, it is desired to increase the mobility of the charge carriers in the channel. For instance, for PMOS devices in such applications, it is desired to increase the mobility of holes in the channel, and for NMOS devices in such applications, it is desired to increase the mobility of electrons in the channel. A technique for increasing charge carrier (e.g., hole or electron) mobility is to impart strain on the channel region of the transistor via the source/drain (S/D) regions. However, as transistors shift to non-planar configurations and scale down to have smaller critical dimensions, such as smaller gate lengths (e.g., sub-100 nanometer (nm) or sub-50 nm gate lengths), the aforementioned strain technique is not effective due to poor mechanical coupling between the channel and the S/D regions. This limits the channel mobilities capable of being achieved to a relatively lower value. In addition, the use of a Si substrate, which is standard for many IC applications, further limits the ability to impart strain on transistor channel regions, as Si provides a single lattice constant or parameter value from which to form subsequent semiconductor material. Accordingly, it can be difficult to form different channel region materials with different strain values, particularly for CMOS applications that utilize both NMOS and PMOS devices.

For instance, NMOS and PMOS devices generally perform better using different materials for the different devices, as different materials can achieve different carrier mobilities depending on whether the carriers are electrons (in the case of NMOS) or holes (in the case of PMOS). For example, in the context of using group IV semiconductor material for transistor channel regions, silicon (Si) or low-germanium (Ge) content silicon germanium (SiGe) is generally preferred for NMOS devices, and high-Ge content SiGe or Ge is generally preferred for PMOS devices. Further, NMOS devices generally perform better with increased tensile strain in the channel region and PMOS devices generally perform better with increased compressive strain in the channel region. Current techniques attempt to achieve the combination of the different strained materials by growing a very thick buffer layer (e.g., 0.5-1 microns, or even thicker) of relaxed SiGe on Si in an attempt to provide the required seeding layer from which to grow the different transistor channel materials while maintaining the preferred strain. Such a thick buffer layer is employed to attain the high relaxation percentage and low surface dislocation density required to provide a suitable seeding layer surface from which to grow the different strained channel region materials. However, employing such a thick buffer layer causes wafer bowing downstream in the IC fabrication process, which is highly undesirable as it can create and/or exacerbate defects and dislocations within the IC devices. Alternatively, employing a relatively thinner buffer layer (e.g., having a thickness of at most 0.5 micron or 500 nm) would cause defects within the thinner buffer layer to propagate to its top surface, thereby affecting the quality of the top surface of the thinner buffer layer. Further, if transistor channel material is grown from that top surface of the thinner buffer layer in an effort to impart strain on the channel material, then the defects would propagate from the top surface of the thinner buffer layer into the channel material, resulting in the loss of strain and thereby degrading charge carrier mobility.

Accordingly, this disclosure presents various embodiments and fabrication techniques that enable transistors with diverse and/or strained channel materials to be formed on an ion-implanted relaxed buffer layer, such as a relaxed, germanium (Ge)-based layer (e.g., silicon germanium (SiGe)) implanted with ions to compensate for strain from defects.

In some embodiments, the relaxed Ge-based layer can be formed with suitable surface quality/relaxation levels via inverse-graded germanium concentration (e.g., Ge fraction of the layer decreasing with thickness away from the Si substrate interface) in the Ge-based layer that serves to generate and effectively trap defects near the substrate/Ge-based layer interface. Thus, by generating the defects at the substrate/Ge-based layer, the Ge-based layer can relax (at least in part) toward its material bulk lattice constant value, while the grading of the Ge concentration can effectively trap those defects (at least in part) near the substrate/Ge-based interface to prevent them from reaching the top surface of the Ge-based layer and from reaching the overlying channel material layer.

Moreover, the Ge-based layer can be implanted with ions in the defective regions to compensate for strain from the defects, which helps eliminate or reduce downstream wafer bowing that may occur if the Ge-based layer is too thick. In this manner, the implanted ions enable the use of a relatively thick Ge-based layer-which helps prevent the defects in the Ge-based layer from propagating into the channel-without causing downstream wafer bow. In some embodiments, for example, the Ge-based layer may have a thickness ranging from 20 nanometers (nm) to 3 microns (µm) without significant impact from downstream wafer bow.

Therefore, the Ge-based layer as described herein enables the formation of one or more channel material layers thereon for a multitude of transistor-based applications, as will be apparent in light of this disclosure. In some embodiments, for example, the relaxed Ge-based layer may serve as a template for the growth of compressively strained PMOS channel material and tensile strained NMOS channel material to achieve gains in hole and electron mobility, respectively, in the channel regions of the devices.

For instance, in some embodiments, the techniques described herein allow for the growth of a thick or thin, relaxed (e.g., with greater than 80% relaxation), SiGe layer (e.g., with a Ge content of less than 35% by atomic percentage at the top surface of the layer) with a low top surface dislocation density (e.g., less than 1E7 atoms per square centimeter) on a Si substrate. In such an example embodiment, the Ge-based layer (e.g., with 30% Ge content by atomic percentage or Si_{0.7}Ge_{0.3} at the top surface) can serve as the template for the growth of compressively strained SiGe channel PMOS devices (e.g., with 50% or 60% Ge content by atomic percentage) and tensile strained Si channel NMOS devices, thereby simultaneously achieving large gains in hole mobility for the PMOS devices and electron mobility for the NMOS devices, which improves the performance of the devices. Further, in such an example embodiment, the PMOS and NMOS devices may be included in a CMOS circuit, where the techniques described herein help facilitate the co-integration (particularly in close proximity) of high-performance PMOS and NMOS devices. Note that although the substrate is referred to herein as a Si substrate, it may include doping in at least a portion of the substrate, in some embodiments. For instance, in some such embodiments, a top portion of the substrate may include p-type dopant (e.g., boron) and/or n-type dopant (e.g., phosphorous, arsenic). However, in other embodiments, the Si substrate may be intrinsic or undoped. Regardless, in some embodiments, the semiconductor material of the Si substrate may essentially consist of Si semiconductor material (with or without included dopant).

The Ge-based layer, in some embodiments, may include silicon and germanium that may or may not be alloyed with tin and/or carbon. The Ge-based layer is referred to herein as such because it at least includes germanium in at least a portion of the layer, and in some cases, throughout the entirety of the layer. For instance, in some embodiments, the Ge-based layer may include monocrystalline Ge or SiGe at the bottom (near the Si substrate), and then transition to SiGe with a relatively lower Ge concentration at the top (near the overlying channel material layer). For instance, in some such embodiments, the Ge concentration may be decreased as the Ge-based layer is being deposited (e.g., via in-situ processing), while the concentration of one or more other elements (e.g., Si, C, and/or Sn) may be increased as the Ge-based layer is deposited. In other embodiments, the Ge concentration of the Ge-based layer may be decreased or inverse-graded using a step-wise approach, where the Ge concentration is abruptly changed (e.g., with at least a 5 or 10% difference in Ge concentration) throughout the Ge-based layer. Such abrupt changes may happen in a layer-by-layer manner, such that the Ge-based layer includes a multilayer structure of progressively decreasing Ge concentration. In still other embodiments, a hybrid approach may be utilized, such as where a step-wise approach is used, but the Ge-concentration is also smoothly graded in at least one sub-layer.

In some embodiments, the decrease in Ge concentration, from the starting relatively high Ge concentration at the bottom (closest to the Si substrate) to the ending relatively low Ge concentration at the top (farthest from the Si substrate), may be in the range of 5-95%, may be approximately 5, 10, 15, 20, 25, 30, 35, 40, 45, 50, 55, 60, 65, 70, 75, 80, 85, 90, or 95%, and/or may be at least 5, 10, 15, 20, 25, 30, 35, 40, 45, 50, 55, 60, 65, 70, 75, 80, 85, 90, or 95%, for example. In the extreme example of the aforementioned range, the Ge-based layer would start as Ge and transition to Si_{0.95}Ge_{0.05}, for instance.

In embodiments where the Ge-based layer includes an inverse-graded Ge concentration based on a step-wise approach (e.g., where distinct interfaces may be present), there may be 1, 2, 3, 4, 5, 6, 7, 8, 9 or more steps in the multilayer structure of the Ge-based layer, for example. Further, in embodiments where the Ge-based layer includes an inverse-graded Ge concentration based on a step-wise approach, the Ge-based layer may include a multilayer structure including 2, 3, 4, 5, 6, 7, 8, 9, 10 or more sub-layers, for example. For instance, if a two-step approach is applied (such that the multilayer structure includes three sub-layers), then the Ge-based layer may start with a first sub-layer of Si_{0.4}Ge_{0.6} at the substrate, followed by a second sub-layer of Si_{0.6}Ge_{0.4} formed on the first sub-layer, followed by a third sub-layer of Si_{0.8}Ge_{0.2} formed on the second sub-layer, where that third sub-layer of the Ge-based layer provides a seeding surface of Si_{0.8}Ge_{0.2} from which to form one or more channel material layers.

In some embodiments, the Ge-based layer may or may not be doped with any suitable dopant (e.g., boron, phosphorous, and/or arsenic). In some embodiments, the Ge-based layer may be included, in part, in the channel region of one or more transistor devices. In other embodiments, the Ge-based layer may be completely below the channel region of a given transistor, where it is completely contained in a sub-channel or sub-fin region, for example. In some such embodiments, the Ge-based layer may be oppositely type doped relative to the overlying channel region material to provide a tunnel diode to help reduce or eliminate parasitic leakage (e.g., subthreshold leakage). For instance, in some embodiments, the Ge-based layer may be intentionally p-type doped (e.g., with a doping concentration of at least 1E16, 5E16, 1E17, 5E17, 1E18, 5E18, or 1E19 atoms per cubic cm) if the overlying channel region is to be n-type doped, or vice versa, where the Ge-based layer may be intentionally n-type doped (e.g., with a doping concentration of at least 1E16, 5E16, 1E17, 5E17, 1E18, 5E18, or 1E19 atoms per cubic cm) if the overlying channel region is to be p-type doped.

As previously stated, by forming the Ge-based layer with inverse grading of the Ge concentration, the Ge-based layer can relax, at least in part, depending on the particular configuration. For instance, in some embodiments, the top surface or portion (e.g., top 1, 2, 3, 4, 5, 10, 15, 20, or 25%) of the Ge-based layer may relax to within 50, 45, 40, 35, 30, 25, 20, 15, 10, or 5% of the bulk lattice parameters of the material of that top surface or portion of the Ge-based layer, for example. By way of example, if the top surface of the Ge-based layer includes SiGe having a concentration of 30% Ge, which has a lattice constant of approximately 5.499 angstroms (Å) at 300 Kelvin (K), and it is formed on a Si substrate with a relaxation value to within 20% of its bulk lattice parameters, then that Si_{0.7}Ge_{0.3} top surface of the Ge-based layer would have a lattice constant of approximately 5.485-5.499 Å at 300 K. Note that the top surface or portion of the Ge-based layer is the relevant surface/portion of concern for the techniques disclosed herein, because it is used as the template/seeding feature from which the channel material layer is formed. Therefore, by shifting the template/seeding surface lattice constant from which the channel material layer is formed (as opposed to the sole lattice constant of Si, which is 5.431 Å at 300 K), the techniques described herein enable a more diverse range of monocrystalline semiconductor material for transistor channels, and also allow such diverse material channel regions to maintain strain throughout the entirety of those channel regions, through material engineering.

As was also previously stated, in the IC stack of layers, the Ge-based layer causes the formation of defects (e.g., dislocations and/or stacking faults) that nucleate at the substrate/Ge-based layer interface and are predominantly contained within the Ge-based layer rather than running through to the overlying channel material layer. In other words, the majority of the defects do not reach the top surface of the Ge-based layer due to the inversely-graded nature of the Ge-based layer and/or the relatively high thickness of the Ge-based layer enabled by the ion implants. Thus, regardless of how the inverse-graded Ge-based layer is formed (e.g., with a smooth gradient or in a step-wise manner), it can be characterized by the nucleation of defects (e.g., dislocations and/or stacking faults) which nucleate at the substrate/Ge-based layer interface and predominantly terminate prior to reaching the top portion/surface of the Ge-based layer. Therefore, the inverse-graded nature of the Ge-based layer (e.g., where the portion of the Ge-based layer nearest the Si substrate includes the highest Ge-concentration of that layer) releases the energy required to form such defects in the first instance, and thus, the Ge-based layer may be considered a high entropy layer. Without the inverse-graded nature of the Ge-based layer, forming a Ge-based layer on a Si substrate would result in relatively more defects propagating to the top surface of the Ge-based layer, particularly for a relatively thin Ge-based layer (e.g., with a thickness of less than 500 nm), which is undesirable as previously described.

In some embodiments, the top portion/surface of the Ge-based layer may have a relatively low defect or dislocation density, such as less than 1E9 per square cm, which is the typical minimum threshold defect/dislocation density that would form at the top portion/surface of the Ge-based layer if the inverse-graded Ge concentration scheme as described herein were not employed. In some such embodiments, the top portion/surface of the Ge-based layer may have a defect/dislocation density of at most 1E9, 5E8, 1E8, 5E7, 1E7, 5E6, 1E6, 5E5, 1E5, 5E4, or 1E4 per square cm, for example. In some embodiments, the top portion/surface of the Ge-based layer may include essentially no defects or dislocations, as they may terminate prior to reaching that top portion/surface. Note that "aEb" as used herein equates to "a times 10 raised to the power of b", where 'a' and 'b' are real numbers. For example, 1E9 can also be expressed as 1 times 10 raised to the power of 9, or simply, 10 to the power of 9 (10^9). Also note that when the top portion/surface or surface/portion of the Ge-based layer is referred to herein, such description may pertain to the top-most surface of the Ge-based layer (e.g., the surface farthest from the Si substrate and closest to the channel material layer) and/or the top portion of the Ge-based layer (e.g., the top 1, 2, 3, 4, 5, 10, 15, or 20% of the Ge-based layer). Thus, reference to the top portion/surface or top surface/portion of the Ge-based layer may mean only the top surface of the Ge-based layer, only the top portion of the Ge-based layer, or both the top surface and the top portion of the Ge-based layer. Also note that in some cases, the defect/dislocation density may include the threading dislocation density. Accordingly, in some embodiments, the interface between the Ge-based layer and the top surface of the Si substrate may become less distinct or essentially merge together (e.g., as a result of the defects formed at that interface).

A channel material layer, in some embodiments, may be formed on the Ge-based layer to be used in the channel region of one or more transistors. In some such embodiments, the channel material layer may include any suitable semiconductor material, such as monocrystalline group IV and/or group III-V semiconductor material. The use of "group IV semiconductor material" (or "group IV material" or generally, "IV") herein includes at least one group IV element (e.g., silicon, germanium, carbon, tin), such as silicon (Si), germanium (Ge), silicon-germanium (SiGe), and so forth. The use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), gallium nitride (GaN), and so forth. Note that group III may also be known as the boron group or IUPAC group 13, group IV may also be known as the carbon group or IUPAC group 14, and group V may also be known as the nitrogen family or IUPAC group 15, for example. Also note that compositionally different as used herein with respect to semiconductor materials or features/layers/structures including semiconductor material means (at least) including different semiconductor materials or including the same semiconductor material but with a different compositional ratio (e.g., where the concentration of at least one component of the material is different). For instance, Ge is compositionally different than InGaAs (as they are different semiconductor materials), but Si_{0.7}Ge_{0.3} is also compositionally different than Si_{0.4}Ge_{0.6} (as they include different compositional ratios). Moreover, SiGe with a Ge concentration in the range of 0 to 30 atomic percentage is compositionally different than SiGe with a Ge concentration in the range of 31 to 100 atomic percentage.

In some embodiments, the channel material layer may be formed such that it is strained to the underlying Ge-based layer. Accordingly, as can be understood based on this disclosure, use of the Ge-based layer described herein can enable different semiconductor channel material to be formed thereon in a strained manner as compared to only using the Si substrate as the template from which the semiconductor channel material is formed. This is because the Ge-based layer has sufficiently high/device quality monocrystalline semiconductor material at and near its top surface due to the reduced defect/dislocation density at that location (as a result of employing the inverse grading described herein). Further, the Ge-based layer is at least partially relaxed, thereby providing a template or seeding layer surface with a different lattice constant than that of Si (which is 5.431 Å at 300 K). This is significant, because the channel material layer would relax if there is a big enough lattice delta between its material and the material on which it is grown (e.g., if the lattice delta reaches the point of being a lattice mismatch, which typically occurs around a lattice delta of 2-3%). Thus, by allowing the lattice constant of the template/seeding surface for that channel material layer to be adjusted, through use of the inverse-graded Ge-based layer as described herein, the techniques described herein enable the formation of a wider range of possible fully strained channel region materials for transistor devices, such as SiGe with relatively higher Ge concentrations (e.g., greater than 30, 35, or 40% Ge by atomic percentage), Si, and various group III-V materials. In some embodiments, a given channel material layer may be strained to the underlying Ge-based layer such that the in-plane lattice parameters of the channel material layer are within 50, 45, 40, 35, 30, 25, 20, 15, 10, or 5%, or essentially the same as, the in-plane lattice parameter at/near the top surface of the Ge-based layer. Further, where a channel material layer is strained (to the underlying Ge-based layer), that strain may extend to essentially the top surface of the channel material layer, such that the channel material layer is strained throughout the layer and maintains the strain through subsequent IC processing to the end structure, in accordance with some embodiments.

In some embodiments, multiple different channel material layers may be formed on different areas of the Ge-based layer, such as for CMOS applications, for example. For instance, a first channel material layer may be formed on a first area of the Ge-based layer to be used for one or more p-channel transistor devices (e.g., one or more PMOS devices) and a second channel material may be formed on a second area of the Ge-based layer to be used for one or more n-channel transistor devices (e.g., one or more NMOS devices). As previously described, by selecting the Ge-based layer to have the desired material (e.g., the desired Ge concentration and/or alloying with Si, C, and/or Sn) and achieving a desired relaxation percentage, the Ge-based layer can provide a template/seeding layer from which to grow the multiple different channel material layers, such that a first channel material used for p-channel transistors may have a relatively higher lattice constant than the template surface to achieve compressive strain and a second channel material used for n-channel transistors may have a relatively lower lattice constant than the template surface to achieve tensile strain. By way of example, employing a Ge-based layer of Si_{0.7}Ge_{0.3} enables the formation of fully-strained (with compressive strain) Si_{0.4}Ge_{0.6} p-channel material on that Si_{0.7}Ge_{0.3} layer, while also allowing for the formation of fully-strained (with tensile strain) Si n-channel material. In such an example, if the Si_{0.4}Ge_{0.6} p-channel material were instead formed on the Si substrate, that Si_{0.4}Ge_{0.6} p-channel material would relax (at least in part) due to the lattice mismatch between Si and Si_{0.4}Ge_{0.6}. Such relaxation caused by the lattice mismatch in the example case (where the techniques described herein are not employed) is undesirable, as it leads to a decrease in charge carrier mobility and thereby degrades the overall performance of the device. Further, if the Si n-channel material were instead formed on the Si substrate, the lattice parameters would be exactly matched, and thus, strain would not be produced in the first instance in that Si n-channel material.

In some embodiments, the techniques described herein can be used to benefit n-channel devices (e.g., NMOS) and/or p-channel devices (e.g., PMOS). Further, in some embodiments, the techniques described herein can be used to benefit MOSFET devices, tunnel FET (TFET) devices, Fermi filter FET (FFFET) devices, and/or any other suitable devices as will be apparent in light of this disclosure. Further still, in some embodiments, the techniques described herein can be used to form complementary transistor circuits (such as CMOS circuits), where the techniques can be used to benefit one or more of the included n-channel and p-channel transistors making up the CMOS circuit. Further yet, in some embodiments, the techniques described herein can be used to benefit a multitude of transistor configurations, such as planar and non-planar configurations, where the non-planar configurations may include finned or FinFET configurations (e.g., dual-gate or tri-gate), gate-all-around (GAA) configurations (e.g., nanowire or nanoribbon), or some combination thereof (e.g., beaded-fin configurations), to provide a few examples. In addition, in some embodiments, the techniques can be used for a variety of source/drain (S/D) configurations, such as replacement material S/D, cladded S/D, and/or any other suitable S/D configuration as will be apparent in light of this disclosure. The techniques described herein may be used to benefit logic transistor devices or transistor-based devices used for other suitable applications (e.g., amplification, switching, etc.). Therefore, the techniques described herein can be used to benefit a multitude of transistor devices. In general, the techniques allow transistors to be further scaled with diverse channel materials, while ensuring lower leakage, higher drive currents, and thereby improved performance.

Note that, as used herein, the expression "X includes at least one of A or B" refers to an X that may include, for example, just A only, just B only, or both A and B. To this end, an X that includes at least one of A or B is not to be understood as an X that requires each of A and B, unless expressly so stated. For instance, the expression "X includes A and B" refers to an X that expressly includes both A and B. Moreover, this is true for any number of items greater than two, where "at least one of" those items is included in X. For example, as used herein, the expression "X includes at least one of A, B, or C" refers to an X that may include just A only, just B only, just C only, only A and B (and not C), only A and C (and not B), only B and C (and not A), or each of A, B, and C. This is true even if any of A, B, or C happens to include multiple types or variations. To this end, an X that includes at least one of A, B, or C is not to be understood as an X that requires each of A, B, and C, unless expressly so stated. For instance, the expression "X includes A, B, and C" refers to an X that expressly includes each of A, B, and C. Likewise, the expression "X included in at least one of A or B" refers to an X that may be included, for example, in just A only, in just B only, or in both A and B. The above discussion with respect to "X includes at least one of A or B" equally applies here, as will be appreciated.

The terms "over," "under," "between," "above," "on," and/or "near" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. Similarly, a first layer "on" a second layer may be directly on (e.g., in direct contact with) the second layer or indirectly on the second layer (e.g., via one or more intervening layers). In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

Use of the techniques and structures provided herein may be detectable using tools such as: electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools may indicate an integrated circuit (IC) including strained transistor channel material on a relaxed, Ge-based layer, with defects at or near the interface of the Ge-based layer and the Si substrate, and the presence of ions implanted among the defects.

For example, in some such embodiments, the relaxed Ge-based layer is inverse-graded with respect to the Ge concentration within the layer. For instance, in some cases, the inverse grading is achieved via a step-wise approach (that may form a multilayer structure that includes distinct interfaces), where the Ge concentration is greatest near the substrate and decreases therefrom to a minimum Ge concentration farthest from the substrate. Regardless of how the inverse-graded Ge concentration is achieved, it can be identified via SIMS, TEM, EDX mapping, and/or atom probe tomography.

Further, in some such embodiments, the Ge-based layer may be characterized by the nucleation of defects (e.g., dislocations and stacking faults) at the substrate/Ge-based layer interface which predominantly terminate prior to reaching the top surface of the Ge-based layer, such that they do not run through to the overlying channel material layer, which may be identified through high resolution TEM imagining, for instance. The Ge-based layer may also be characterized by the presence of ions implanted among the defects, such as ion species of carbon (C), tin (Sn), boron (B), phosphorus (P), and/or arsenic (As), among other examples. Moreover, the implanted ions compensate for strain from the defects, which enables the use of a relatively thick Ge-based layer without causing downstream wafer bow. Thus, in some embodiments, the Ge-based layer may also be characterized by being relatively thick (e.g., 200 nm - 3 µm).

Thus, at least the top portion of the inverse-graded (e.g., having a Ge concentration change that goes from a relatively high concentration, such as 100, 90, 80, 70, 60, 50, 40, 30, or 20% Ge to a relatively low concentration, such as 5, 10, 20, 30, 40, 50, 60, 70, or 80%), relaxed (e.g., having an actual lattice constant at the top surface that is within 50, 40, 30, 20, or 10% of its bulk material fully relaxed lattice constant), Ge-based (e.g., at least including germanium, while also including at least one of Si, C, and Sn) layer may include relatively less defects (e.g., a defect density of at most 1E9, 5E8, 1E8, 5E7, 1E7, 5E6, 1E6, 5E5, 1E5, 5E4, or 1E4 per square cm) than if the inverse grading of the Ge concentration in the Ge-based layer, and/or a relatively thick Ge-based layer enabled by ion implants, were not employed.

In some embodiments, the techniques described herein may be detected based on the benefits derived from their use, which includes diverse channel materials (particularly diverse and fully strained channel materials), relatively lower leakage, relatively higher drive currents (e.g., as a result of the strain achievable in the channel region which increases channel mobility), and/or other improved device performance. Numerous configurations and variations will be apparent in light of this disclosure.

### Architecture and Methodology

As explained above, growth of transistor channel material on top of a thick relaxed buffer can simultaneously provide the appropriate channel stress for both NMOS and PMOS transistors. For example, the deposition of silicon (Si) channels for NMOS and silicon germanium (SiGe) channels for PMOS on top of a thick, relaxed germanium-based buffer (e.g., SiGe) results in tensile strain in the NMOS channel and compressive strain in the PMOS channels, generating improved mobility and drive current in both cases. The downside to this thick relaxed buffer layer is that it often causes a large wafer bow due to defects resulting from relaxation, which in turn causes problems with lithography and downstream device processing. As a result, many solutions attempt to reduce wafer bow by growing thick strain compensating layers on the backside of the wafer. However, this approach results in cumbersome processing that is very time consuming and expensive from a manufacturability perspective.

Accordingly, this disclosure presents embodiments that leverage a relaxed buffer layer (e.g., a Ge- or SiGe-based layer) with ion implants for strain compensation to prevent or reduce wafer bow. For example, ions are implanted into the relaxed buffer layer to generate compensating stressors for the defects resulting from relaxation, which ultimately reduces the wafer bow. In particular, the ion implants are targeted for the defective region of the relaxed buffer layer near the substrate interface, which typically has the highest concentration of relaxation defects. Moreover, with proper masking, different ions can be utilized for stress compensation in respective NMOS and PMOS regions, as needed to reduce wafer bow.

This solution provides numerous advantages. In particular, strain compensation via ion-implanted species in the relaxed buffer layer provides greater control over the amount of strain compensation and can be patterned to provide localized strain compensation. As a result, the described solution is more effective at reducing wafer bow than previous approaches, and also requires less complicated processing during fabrication, which reduces costs.

This solution can be utilized on NMOS and PMOS transistors, alternative architectures such as nanowires, TFETs, FINFETs, RibbonFETS, stacked CMOS, and/or other semiconductor devices, and on a variety of channel materials, including materials containing silicon (Si), germanium (Ge), tin (Sn), indium (In), gallium (Ga), arsenic (As), aluminum (Al), and/or antimony (Sb), among other examples.

This solution can also be tuned for different embodiments by varying the number of ion-implanted layers, the location and/or concentration of implanted ions, the species of implanted ions, and so forth. In various embodiments, for example, the ion-implanted species may include carbon (C), tin (Sn), boron (B), phosphorus (P), and/or arsenic (As), among other examples. Moreover, the strain-compensating ion species can also be implanted post-patterning to provide localized strain compensation. This solution can also be incorporated in a variety of existing process flows, including "gate last" and "gate first" flows, flows that grow the relaxed buffer and channel as blanket layers (e.g., blanket deposition flows) or in trenches (e.g., replacement fin and/or aspect ratio trapping (ART) flows), and so forth.

Moreover, in some embodiments, the described solution can be detected based on the presence of compensating stressors in the relaxed buffer near the substrate, such as by detecting the presence of one or more ion-implanted species (e.g., carbon (C), tin (Sn), boron (B), phosphorus (P), arsenic (As)) using techniques such as energy-dispersive X-ray spectroscopy (EDX) in transmission electron microscopy (TEM) or scanning electron microscopy (SEM), secondary ion mass spectrometry (SIMS), atom probe tomography (APT), and so forth.

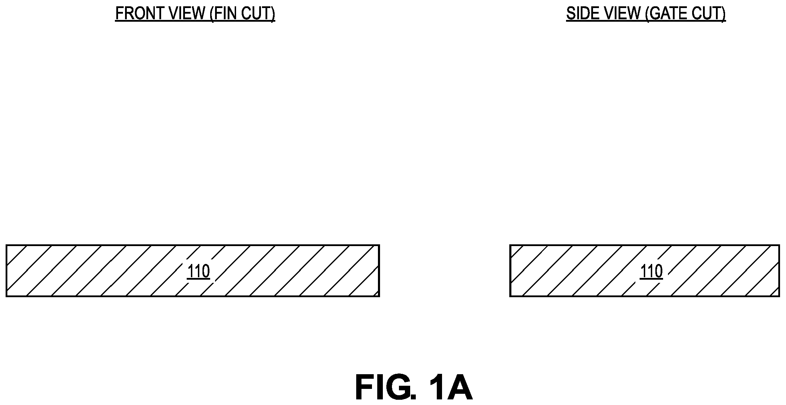

FIGS. 1A-I illustrate cross-section views of example integrated circuit (IC) structures formed on a relaxed buffer (e.g., a relaxed Germanium-based layer) with ion implants for strain compensation at various stages of fabrication. In particular, front-view (e.g., fin cut) and sideview (e.g., gate cut) cross-sections are shown for fin field-effect transistors (FinFETs) fabricated using a "gate last" process flow with blanket deposition of the relaxed buffer and channel layer materials.

The process flow begins with FIG. 1A, where a substrate 110 is provided. In some embodiments, the substrate 110 may be a silicon (Si) substrate, such as a bulk Si substrate (e.g., a bulk Si wafer), a Si on insulator (SOI) structure, or any other suitable starting substrate where the top layer includes Si or another suitable semiconductor material.

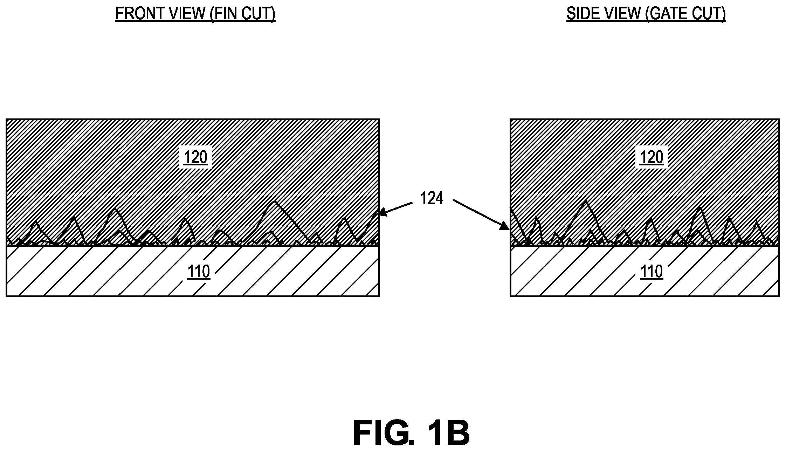

In FIG. 1B, a relaxed buffer layer 120-such as a relaxed, germanium (Ge)-based layer (e.g., SiGe)-is formed on the substrate 110 (e.g., using the techniques described throughout this disclosure), which includes defects 124 caused by relaxation near the interface with the substrate 110.

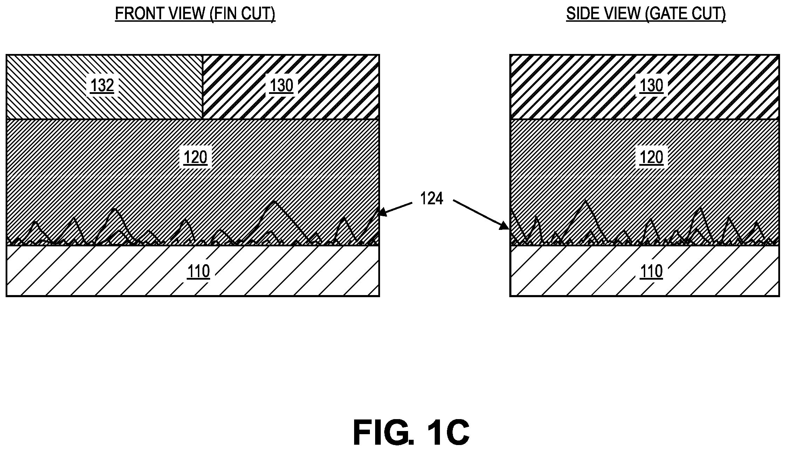

In FIG. 1C, multiple channel materials 130, 132 are deposited on the relaxed buffer 120 to form multiple types of transistor channels, such as a tensile-strained silicon (Si) channel 130 for NMOS transistors and a compressively-strained silicon germanium (SiGe) channel 132 for PMOS transistors. In some embodiments, for example, including CMOS applications, multiple different channel material layers 130, 132 may be formed on different areas of the relaxed Ge-based layer 120. For instance, a first channel material 130 may be deposited on a first area of the Ge-based layer 120 for one or more n-channel transistor devices (e.g., NMOS devices) and a second channel material 132 may be deposited on a second area of the Ge-based layer 120 for one or more p-channel transistor devices (e.g., PMOS devices). Moreover, by tuning the material(s) used in the relaxed Ge-based layer 120 (e.g., the desired Ge concentration and/or alloying with Si, C, and/or Sn) and achieving a desired relaxation percentage, the Ge-based layer 120 can provide a template/seeding layer from which to grow the multiple different channel material layers, such that a first channel material used for p-channel transistors may have a relatively higher lattice constant than the template surface to achieve compressive strain and a second channel material used for n-channel transistors may have a relatively lower lattice constant than the template surface to achieve tensile strain.

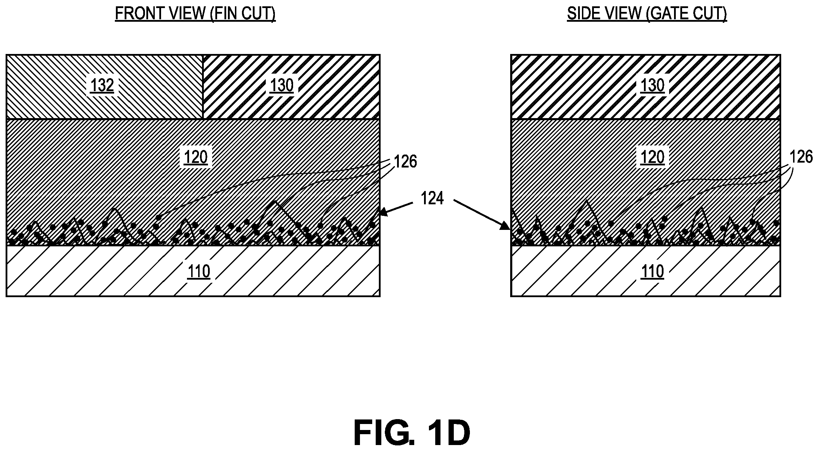

In FIG. 1D, ions 126 are implanted in the defective regions 124 of the relaxed buffer layer 120 and/or the substrate 110, at or near the interface of those layers, which is where the relaxation defects 124 are primarily concentrated. In particular, the implanted ions 126 provide strain compensation for the relaxation defects 124, which helps reduce or avoid wafer bow during downstream fabrication processing. In this manner, by reducing the effects of wafer bow, the implanted ions 126 enable the use of a relatively thick buffer layer 120, which helps prevent relaxation defects 124 from propagating into the channel layers 130, 132.

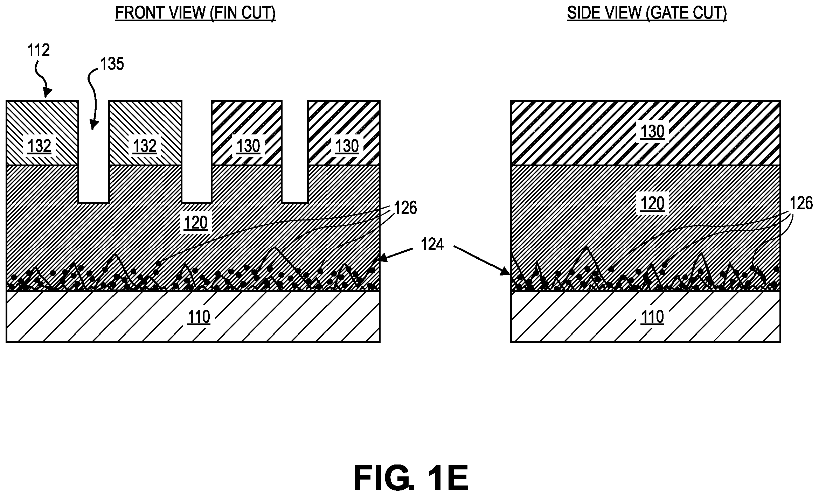

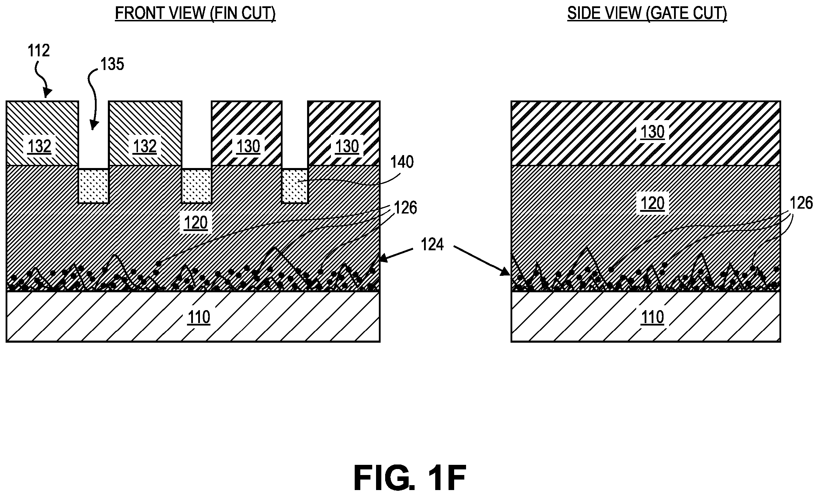

In FIG. 1E, trenches 135 are etched in the channel layers 130, 132 to pattern fins 112 in those layers, and in FIG. 1F, the trenches 135 are at least partially filled with shallow trench isolation (STI) material 140.

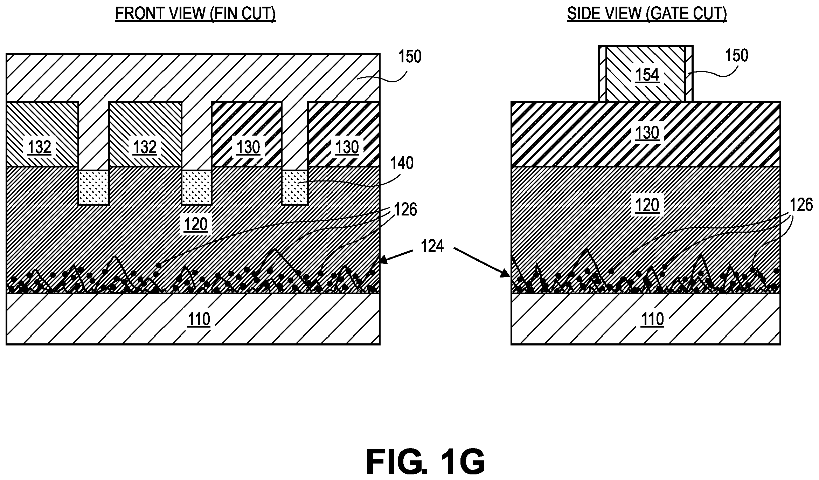

In FIG. 1G, a gate spacer 150 and dummy gate 154 are formed on or above the channel layers 130, 132.

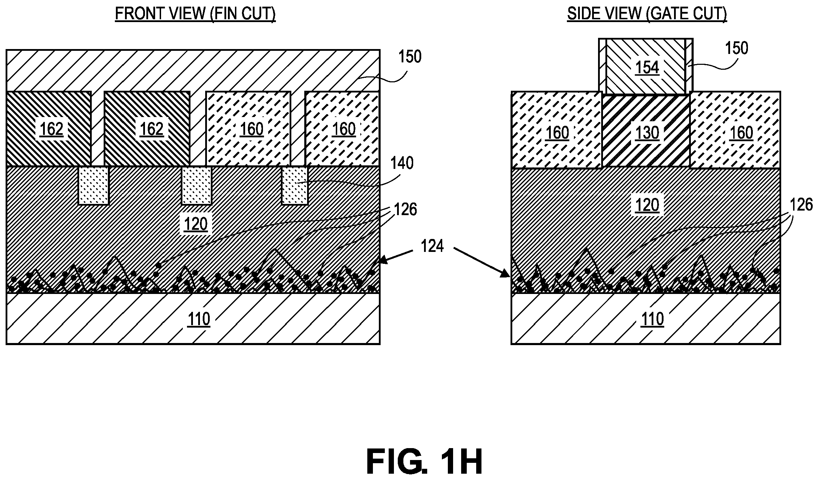

In FIG. 1H, source and drain regions 160, 162 are formed on or above the buffer layer 120 on the sides of the channel layers 130, 132. In some embodiments, for example, n-type source/drain regions 160 may be formed on the sides of the tensile-strained Si channel 130 for the NMOS transistors, and p-type source/drain regions 162 may be formed on the sides of the compressive-strained SiGe channel 132 for the PMOS transistors.

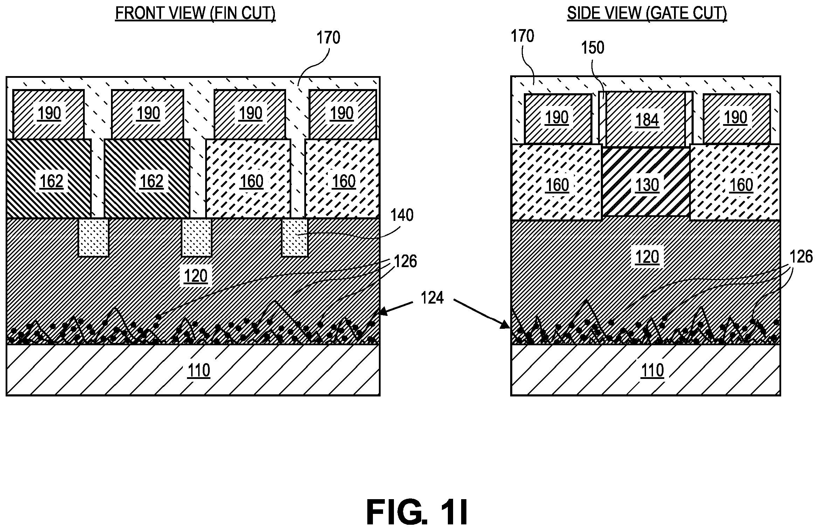

In FIG. 1I, the final gate structure 184 is formed by replacing the dummy gate 154 with a suitable gate metal, and source/drain contacts 190 are formed on the respective source/drain regions 160, 162. The remaining area is filled with an inter-layer dielectric (ILD) 170.

At this point, the transistor structures are complete, and additional downstream processing may be performed to fabricate the remainder of the integrated circuit.

The remaining figures and corresponding descriptions present various materials, layer arrangements, and fabrication techniques that can be used to fabricate the transistor structures of FIGS. 1A-I. Thus, in various embodiments, the transistor structures of FIGS. 1A-I may be implemented using any of the materials, layer arrangements, and/or fabrication techniques described below in connection with the remaining figures.

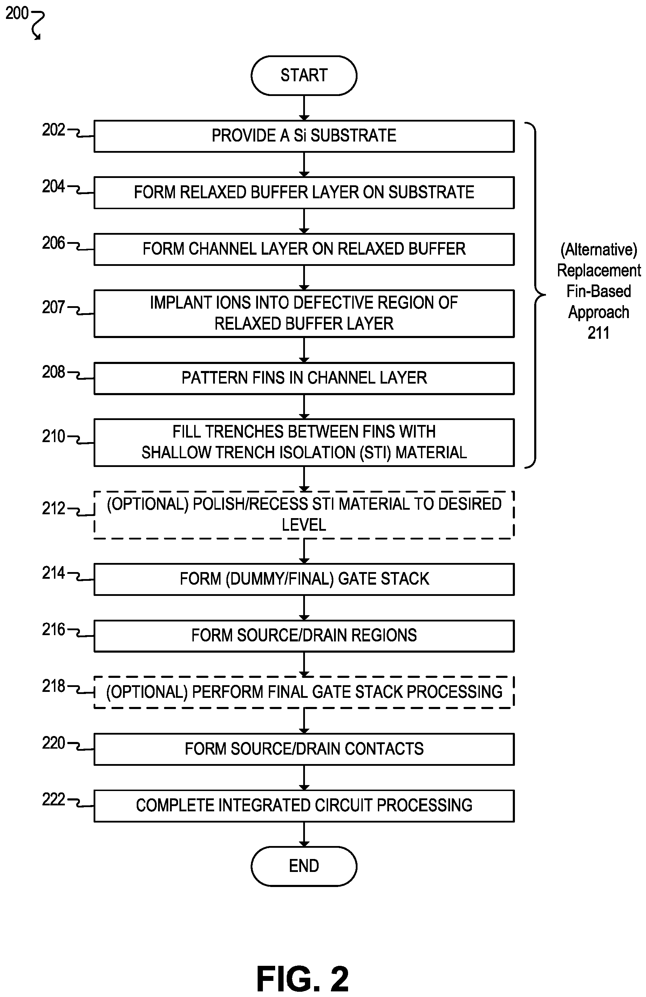

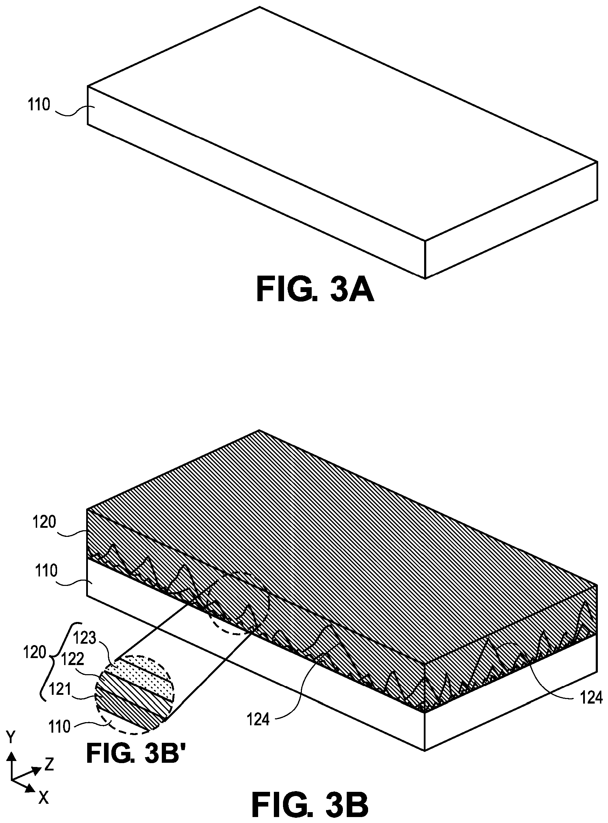

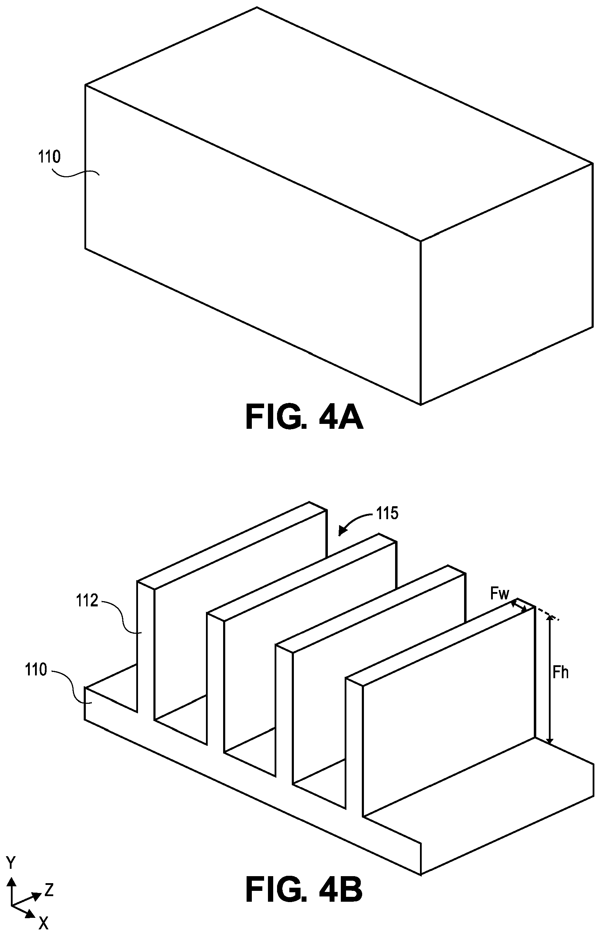

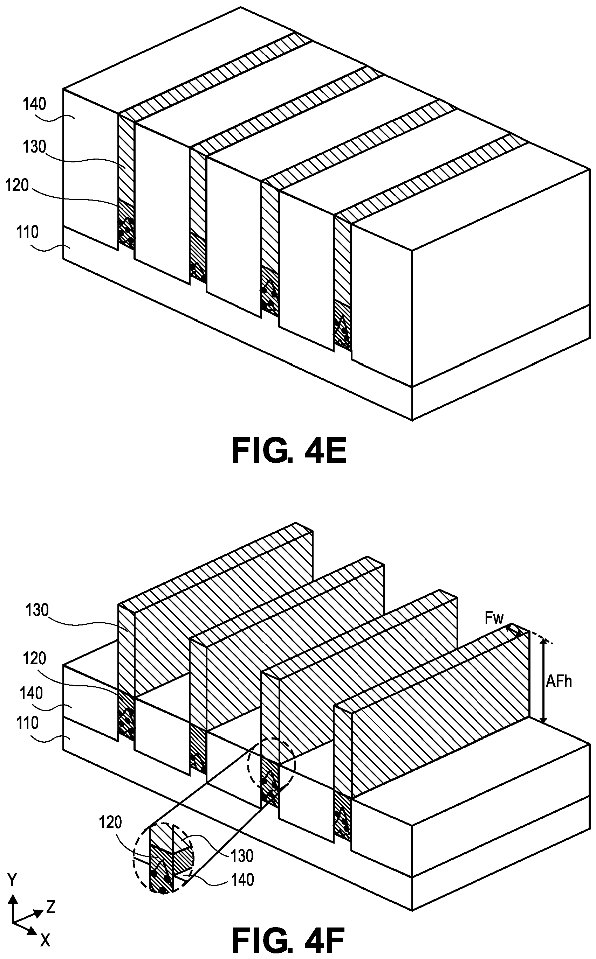

FIG. 2 illustrates a method 200 of forming an integrated circuit (IC) with transistors that include diverse and/or strained channel materials enabled by an ion-implanted relaxed buffer layer, such as a relaxed, germanium (Ge)-based layer (e.g., silicon germanium (SiGe)) implanted with ions 126 to compensate for strain from defects 124. FIGS. 3A-D and 4A-J illustrate example IC structures formed when carrying out method 200 of FIG. 2, in accordance with certain embodiments. Note that the techniques and structures described herein are primarily depicted and described in the context of forming finned or FinFET transistor configurations (e.g., tri-gate transistor configurations), for ease of illustration. However, in some embodiments, the techniques may be used to form transistors of any suitable geometry or configuration, as will be apparent in light of this disclosure. Also note that the techniques for forming the finned structures used in the channel region of one or more transistors may include blanket deposition techniques (e.g., using processes 202-210 to form the structures of FIGS. 3A-D and 4E), replacement fin techniques (e.g., to form the structures of FIGS. 4A-E), and/or any other suitable techniques as will be apparent in light of this disclosure. Further note that method 200 includes alternative paths for both a "gate last" transistor fabrication process flow (e.g., a replacement gate process flow) and a "gate first" process flow, as described further below. Numerous variations and configurations will be apparent in light of this disclosure.

A multitude of different transistor devices can benefit from the techniques described herein, which includes, but is not limited to, various field-effect transistors (FETs), such as metal-oxide-semiconductor FETs (MOSFETs), tunnel FETs (TFETs), and Fermi filter FETs (FFFETs) (also known as tunnel source MOSFETs), to name a few examples. For example, the techniques may be used to benefit an n-channel MOSFET (NMOS) device, which may include a source-channel-drain scheme of n-p-n or n-i-n, where 'n' indicates n-type doped semiconductor material, 'p' indicates p-type doped semiconductor material, and 'i' indicates intrinsic/undoped semiconductor material (which may also include nominally undoped semiconductor material, including dopant concentrations of less than 1E16 atoms per cubic centimeter (cm), for example), in accordance with some embodiments. In another example, the techniques may be used to benefit a p-channel MOSFET (PMOS) device, which may include a source-channel-drain scheme of p-n-p or p-i-p, in accordance with some embodiments. In yet another example, the techniques may be used to benefit a TFET device, which may include a source-channel-drain scheme of p-i-n or n-i-p, in accordance with some embodiments. In still another example, the techniques may be used to benefit a FFFET device, which may include a source-channel-drain scheme of np-i-p (or np-n-p) or pn-i-n (or pn-p-n), in accordance with some embodiments.

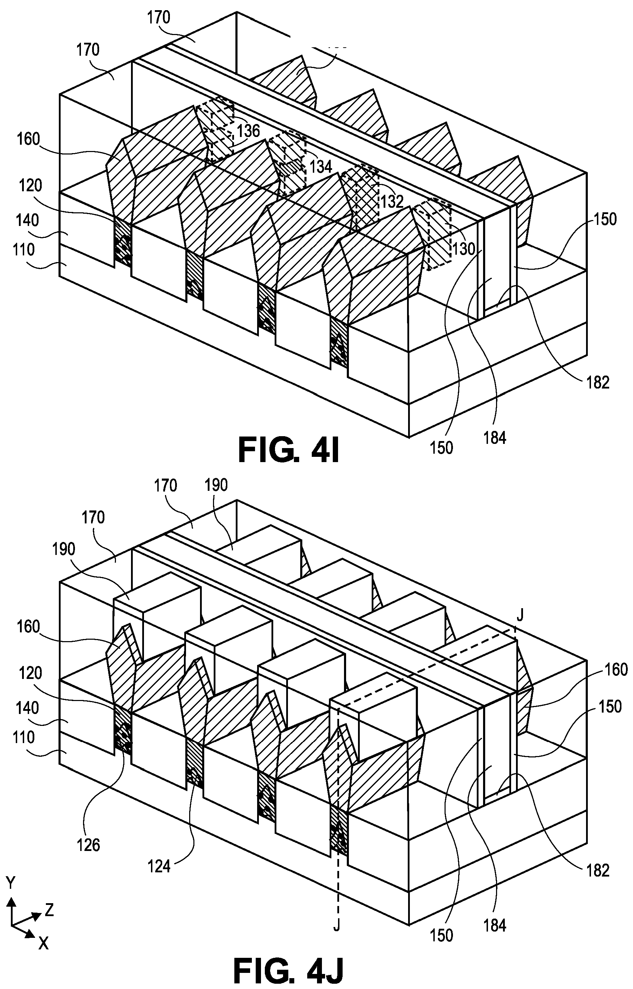

In addition, in some embodiments, the techniques may be used to benefit transistors including a multitude of configurations, such as planar and/or non-planar configurations, where the non-planar configurations may include finned or FinFET configurations (e.g., dual-gate or tri-gate), gate-all-around (GAA) configurations (e.g., nanowire or nanoribbon), or some combination thereof (e.g., a beaded-fin configurations), to provide a few examples. For instance, FIG. 4I illustrates an example IC structure including transistors having finned and nanowire configurations, as will be described in more detail below. Further, the techniques may be used to benefit complementary transistor circuits, such as complementary MOS (CMOS) circuits, where the techniques may be used to benefit one or more of the included n-channel and/or p-channel transistors making up the CMOS circuit. Other example transistor devices that can benefit from the techniques described herein include few to single electron quantum transistor devices, in accordance with some embodiments. Further still, any such devices may employ semiconductor materials that are three-dimensional crystals as well as two dimensional crystals or nanotubes, for example. In some embodiments, the techniques may be used to benefit devices of varying scales, such as IC devices having critical dimensions in the micrometer (micron) range and/or in the nanometer (nm) range (e.g., formed at the 22, 14, 10, 7, 5, or 3 nm process nodes, or beyond).

Method 200 of FIG. 2 begins at block 202 by providing a silicon (Si) substrate 110 as shown in the example of FIG. 3A, in accordance with some embodiments. Substrate 110, in some embodiments may include a bulk Si substrate (e.g., a bulk Si wafer), a Si on insulator (SOI) structure where an insulator/dielectric material (e.g., an oxide material, such as silicon dioxide) is sandwiched between two Si layers (e.g., in a buried oxide (BOX) structure), or any other suitable starting substrate where the top layer includes Si. In some embodiments, substrate 110 may be doped with any suitable n-type and/or p-type dopant at a dopant concentration in the range of 1E16 to 1E22 atoms per cubic cm, for example. For instance, the Si of substrate 110 may be p-type doped using a suitable acceptor (e.g., boron) or n-type doped using a suitable donor (e.g., phosphorous, arsenic) with a doping concentration of at least 1E16 atoms per cubic cm. However, in some embodiments, substrate 110 may be undoped/intrinsic or relatively minimally doped (such as including a dopant concentration of less than 1E16 atoms per cubic cm), for example. In general, although substrate 110 is referred to herein as a Si substrate, in some embodiments, it may essentially consist of Si, while in other embodiments, the substrate may primarily include Si but may also include other material (e.g., dopant at a given concentration). Also note that the substrate 110 may include relatively high quality or device quality monocrystalline Si that provides a suitable template/seeding surface from which other monocrystalline semiconductor material features and layers can be formed. Therefore, unless otherwise explicitly stated, a Si substrate as described herein is not intended to be limited to a substrate that only includes Si.

In some embodiments, substrate 110 may include a surface crystalline orientation described by a Miller index of (100), (110), or (111), or its equivalents, as will be apparent in light of this disclosure. Although substrate 110, in this example embodiment, is shown as having a thickness (dimension in the Y-axis direction) similar to other layers in the figures for ease of illustration, in some instances, substrate 110 may be relatively much thicker than some of the other layers (excluding, in some cases, the relaxed buffer layer 120 which may also be relatively thick), such as having a thickness in the range of 1 to 950 microns (or in the sub-range of 20 to 800 microns), for example, or any other suitable thickness value or range as will be apparent in light of this disclosure.

In some embodiments, substrate 110 may include a multilayer structure including two or more distinct layers (that may or may not be compositionally different). In some embodiments, substrate 110 may include grading (e.g., increasing and/or decreasing) of one or more material concentrations throughout at least a portion of the substrate 110. In some embodiments, substrate 110 may be used for one or more other IC devices, such as various diodes (e.g., light-emitting diodes (LEDs) or laser diodes), various transistors (e.g., MOSFETs or TFETs), various capacitors (e.g., MOSCAPs), various microelectromechanical systems (MEMS), various nanoelectromechanical systems (NEMS), various radio frequency (RF) devices, various sensors, or any other suitable semiconductor or IC devices, depending on the end use or target application. Accordingly, in some embodiments, the structures described herein may be included in a system-on-chip (SoC) application, as will be apparent in light of this disclosure.

Method 200 of FIG. 2 continues at block 204 by forming a relaxed buffer layer 120, such as a relaxed, germanium (Ge)-based layer (referred to simply as a relaxed layer or Ge-based layer), on the Si substrate of FIG. 3A to form the example resulting structure of FIG. 3B, which includes defects 124 caused by relaxation near the interface of the relaxed layer 120 and the substrate 110.

In some embodiments, the Ge-based layer 120 may be formed using any suitable processing, such as via chemical vapor deposition (CVD), physical vapor deposition (PVD), atomic layer deposition (ALD), vapor-phase epitaxy (VPE), molecular-beam epitaxy (MBE), liquid-phase epitaxy (LPE), spin-on processing, and/or any other suitable technique as can be understood based on this disclosure. The Ge-based layer 120, in some embodiments, may include SiGe or Ge that may or may not be alloyed with tin (Sn) and/or carbon (C). In other words, in some such embodiments, Ge-based layer 120 is a monocrystalline group IV semiconductor material that at least includes germanium. In some embodiments, Ge-based layer 120 includes silicon and germanium that may or may not be alloyed with tin and/or carbon. Ge-based layer 120 is referred to herein as such because it at least includes germanium in at least a portion of the layer 120, and in some cases, throughout the entirety of the layer 120. For instance, in some embodiments, Ge-based layer 120 may include monocrystalline Ge or SiGe at the bottom (near the Si substrate), and then transition to SiGe with a relatively lower Ge concentration at the top (near the overlying channel material layer).

In some embodiments, the Ge-based layer 120 includes inverse-graded Ge concentrations, such that it includes a relatively higher Ge concentration in a bottom portion (near substrate 110) and a relatively lower Ge concentration in a top portion (away from substrate 110 and near subsequently formed channel material layer 130), where there may or may not be one or more intermediate portions with varying Ge concentrations between the bottom and top portions. For instance, the inverse-graded nature of Ge-based layer 120 is illustrated in FIG. 3B, where the darker shading of the layer indicates relatively higher Ge concentration and the lighter shading of the layer indicates relatively lower Ge concentration.

For instance, in some such embodiments, the Ge concentration may be decreased as the Ge-based layer 120 is being deposited (e.g., via in-situ processing), while the concentration of one or more other elements (e.g., Si, C, and/or Sn) may be increased as the Ge-based layer 120 is deposited.

In other embodiments, the Ge concentration of the Ge-based layer 120 is decreased or inverse-graded using a step-wise approach, where the Ge concentration is abruptly changed (e.g., with at least a 5% difference in Ge concentration) throughout the Ge-based layer 120. Such abrupt changes may happen in a layer-by-layer manner, such that the Ge-based layer 120 includes a multilayer structure of progressively decreasing Ge concentration. For instance, FIG. 3B' illustrates a blown-out portion of FIG. 3B showing a multilayer Ge-based layer 120' formed with a step-wise approach, in accordance with some embodiments. As shown in FIG. 3B' the multilayer Ge-based layer 120' includes three sub-layers, 121, 122, and 123, where the Ge concentration is relatively highest in layer 121, relatively lowest in layer 123, and at an intermediate concentration in layer 122 (which is indicated by the shading of the layers). Note that sub-layers 121, 122, and 123 are all shown as having the same thickness (dimension in the Y-axis direction), the present disclosure is not intended to be so limited, as they may have varying thicknesses, for example. In still other embodiments, a hybrid approach may be utilized, such as where a step-wise approach is used, but the Ge-concentration is also smoothly graded in at least one sub-layer.

In some embodiments, the decrease in Ge concentration of the Ge-based layer, from the starting relatively high Ge concentration at the bottom (closest to the Si substrate 110) to the ending relatively low Ge concentration at the top (farthest from the Si substrate 110), may be in the range of 5-95%, may be approximately 5, 10, 15, 20, 25, 30, 35, 40, 45, 50, 55, 60, 65, 70, 75, 80, 85, 90, or 95%, and/or may be at least 5, 10, 15, 20, 25, 30, 35, 40, 45, 50, 55, 60, 65, 70, 75, 80, 85, 90, or 95%, for example. In the extreme example of the aforementioned range, the Ge-based layer 120 would start as Ge and transition to Si_{0.95}Ge_{0.05}, for instance.

In embodiments where the Ge-based layer 120 includes an inverse-graded Ge concentration based on a step-wise approach (e.g., where distinct interfaces may be present), there may be 1, 2, 3, 4, 5, 6, 7, 8, 9 or more steps in the multilayer structure of the Ge-based layer 120, for example. Further, in embodiments where the Ge-based layer 120 includes an inverse-graded Ge concentration based on a step-wise approach, the Ge-based layer 120 may include a multilayer structure including 2, 3, 4, 5, 6, 7, 8, 9, 10 or more sub-layers, for example. For instance, if a two-step approach is applied (such that the multilayer structure includes three sub-layers), then the Ge-based layer 120 may start with a first sub-layer of Si_{0.4}Ge_{0.6} at the substrate, followed by a second sub-layer of Si_{0.6}Ge_{0.4} formed on the first sub-layer, followed by a third sub-layer of Si_{0.8}Ge_{0.2} formed on the second sub-layer, where that third sub-layer of the Ge-based layer 120 provides a seeding surface of Si_{0.8}Ge_{0.2} from which to form one or more channel material layers. Thus, the inverse-graded nature of the Ge-based layer 120 variously described herein can be in any form, as long as there is an overall decrease in the Ge concentration going away from the substrate (which may equate to an overall increase in Si concentration going away from the substrate, in some embodiments).

In some embodiments, the Ge-based layer 120 may or may not be doped with any suitable dopant (e.g., boron, phosphorous, and/or arsenic). In embodiments where the Ge-based layer 120 is doped, it may be n-type doped (e.g., with phosphorous or arsenic) or p-type doped (e.g., with boron) at a dopant concentration in the range of 1E16 to 1E22 atoms per cubic cm, for example. In some embodiments, Ge-based layer 120 may include a multilayer structure including two or more distinct layers (that may or may not be compositionally different). For instance, in embodiments where the Ge concentration in the Ge-based layer 120 is inversely graded using a step-wise or incremental manner, the Ge-based layer 120 may include a multilayer structure.

By forming the Ge-based layer 120 with inverse grading of the Ge concentration, the Ge-based layer 120 can relax, at least in part, depending on the particular configuration. For instance, in some embodiments, the top surface or portion (e.g., top 1, 2, 3, 4, 5, 10, 15, 20, or 25%) of the Ge-based layer 120 may relax to within 50, 45, 40, 35, 30, 25, 20, 15, 10, or 5% of the bulk lattice parameters of the material of that top surface or portion of the Ge-based layer 120, for example. By way of example, if the top surface of the Ge-based layer 120 includes SiGe having a concentration of 30% Ge, which has a lattice constant of approximately 5.499 Å at 300 K, and it is formed on a Si substrate with a relaxation value to within 20% of its bulk lattice parameters, then that Si_{0.7}Ge_{0.3} top surface of the Ge-based layer 120 would have a lattice constant of approximately 5.485-5.499 Å at 300 K. Note that the top surface or portion of the Ge-based layer 120 is the relevant surface/portion of concern for the techniques disclosed herein, because it is used as the template/seeding feature from which the channel material layer is formed. Therefore, by shifting the template/seeding surface lattice constant from which the channel material layer is formed (as opposed to the sole lattice constant of Si, which is 5.431 Å at 300 K), the techniques described herein enable a more diverse range of monocrystalline semiconductor material for transistor channels, and also allow such diverse material channel regions to maintain strain throughout the entirety of those channel regions, through material engineering.

In some embodiments, the lattice parameter of the bottom-most portion of the Ge-based layer 120 (nearest to the Si substrate 110) may be relatively higher than the lattice parameter of the top-most portion of the Ge-based layer 120 (farthest from the Si substrate 110 and closest to the channel material layer 130). In some such embodiments, the lattice parameter of the bottom-most portion of the Ge-based layer (which may include the highest Ge concentration in the Ge-based layer 22) may be at least 0.01, 0.02, 0.03, 0.04, 0.05, 0.06, 0.07, 0.08, 0.09, 0.10, 0.11, 0.12, 0.13, 0.14, 0.15, 0.16, 0.17, 0.18, 0.19, 0.2, 0.21, or 0.22 Å at 300 K greater than the lattice parameter of the top-most portion of the Ge-based layer (which may include the lowest Ge concentration in the Ge-based layer 120), or some other suitable threshold value as will be apparent in light of this disclosure. Numerous different ways of characterizing the inverse grading of the Ge-based layer 120 will be apparent in light of this disclosure.

In some embodiments, the Ge-based layer 120 causes the formation of defects 124 (e.g., dislocations and/or stacking faults) that nucleate at the substrate 110/Ge-based layer 120 interface and are predominantly contained within the Ge-based layer 120 rather than running through to the overlying channel material layer 130. In other words, the majority of the defects 124 do not reach the top surface of the Ge-based layer 120 due to the inversely-graded nature of the Ge-based layer 120 and/or the relatively high thickness of the Ge-based layer 120 enabled by the ion implants 126, as described further below. Thus, regardless of how the inverse-graded Ge-based layer 120 is formed (e.g., with a smooth gradient or in a step-wise manner), it can be characterized by the nucleation of defects 124 (e.g., dislocations and/or stacking faults) which nucleate at the substrate/Ge-based layer interface and predominantly terminate prior to reaching the top portion/surface of the Ge-based layer 120. Therefore, the inverse-graded nature of the Ge-based layer 120 (e.g., where the portion of the Ge-based layer nearest the Si substrate 110 includes the highest Ge-concentration of that layer) releases the energy required to form such defects in the first instance, and thus, the Ge-based layer 120 may be considered a high entropy layer. Without the inverse-graded nature of the Ge-based layer 120, forming a Ge-based layer on a Si substrate would result in relatively more defects propagating to the top surface of the Ge-based layer, particularly for a relatively thin Ge-based layer (e.g., with a thickness of less than 500 nm), which is undesirable as previously described.

Moreover, in various embodiments, the thickness of the Ge-based layer 120 can vary widely (e.g., vertical thickness in Y-axis direction), including from a relatively thin Ge-based layer 120 (e.g., 20-200 nm) to a relatively thick Ge-based layer 120 (e.g., 200 nm - 3 µm). In particular, a relatively thin Ge-based layer 120 helps reduce downstream wafer bow but increases the risk of defects 124 propagating into the channel 130. On the other hand, a relatively thick Ge-based layer 120 helps prevent defects 124 from propagating into the channel 130 but increases the risk of downstream wafer bow. As described further below, however, the Ge-based layer 120 can be implanted with ions 126 in the defective regions to compensate for strain from the defects 124, which helps eliminate or reduce downstream wafer bowing. In this manner, the implanted ions 126 enable the use of a relatively thick Ge-based layer 120-which helps prevent the defects 124 from propagating into the channel 130-without causing significant downstream wafer bow. As a result, in various embodiments and use cases, the thickness of the Ge-based layer 120 can be tuned to achieve an optimal balance between preventing defects 124 from propagating into the channel 130 and reducing the potential for downstream wafer bow.

Other suitable materials and thickness values/ranges/thresholds will be apparent in light of this disclosure. Also note that in general, the inverse grading described herein for Ge-based layer 120 is with respect to the Y-axis direction or within a suitable plus/minus (e.g., within 15 degrees) of Y-axis. In other words, the inverse grading is generally with respect to the vertical thickness of the Ge-based layer 120, for example.

In some embodiments, the top portion/surface of the Ge-based layer 120 may have a relatively low defect or dislocation density, such as less than 1E9 per square cm, which is the typical minimum threshold defect/dislocation density that would form at the top portion/surface of the Ge-based layer if the inverse-graded Ge concentration and/or ion implantation schemes described herein were not employed. In some such embodiments, the top portion/surface of the Ge-based layer 120 may have a defect/dislocation density of at most 1E9, 5E8, 1E8, 5E7, 1E7, 5E6, 1E6, 5E5, 1E5, 5E4, or 1E4 per square cm, for example. In some embodiments, the top portion/surface of the Ge-based layer 120 may include essentially no defects or dislocations, as they may terminate prior to reaching that top portion/surface. Note that when the top portion/surface or surface/portion of the Ge-based layer 120 is referred to herein, such description may pertain to the top-most surface of the Ge-based layer 120 (e.g., the surface farthest from the Si substrate and closest to the channel material layer) and/or the top portion of the Ge-based layer (e.g., the top 1, 2, 3, 4, 5, 10, 15, or 20% of the Ge-based layer). Thus, reference to the top portion/surface or top surface/portion of the Ge-based layer 120 may mean only the top surface of the Ge-based layer 120, only the top portion of the Ge-based layer 120, or both the top surface and the top portion of the Ge-based layer 120. Also note that in some cases, the defect/dislocation density may include the threading dislocation density. Accordingly, in some embodiments, the interface between the Ge-based layer 120 and the top surface of the Si substrate 110 may become less distinct or essentially merge together (e.g., as a result of the defects formed at that interface).

In some embodiments, the Ge-based layer 120 may be included, in part, in the channel region of one or more transistor devices. In other embodiments, the Ge-based layer 120 may be completely below the channel region of a given transistor, where it is completely contained in a sub-channel or sub-fin region, for example. In some such embodiments, the Ge-based layer 120 can be used as a template or a seeding layer from which to form various different channel material layers, as will be described in more detail below. Further, in some such embodiments, the Ge-based layer 120 may be oppositely type doped relative to the overlying channel material layer 130 to provide a tunnel diode configuration to help reduce or eliminate parasitic leakage (e.g., subthreshold leakage). For instance, in some embodiments, the Ge-based layer 120 may be intentionally p-type doped (e.g., with a doping concentration of at least 1E16, 5E16, 1E17, 5E17, 1E18, 5E18, or 1E19 atoms per cubic cm) if the overlying channel material layer 130 is to be n-type doped, or vice versa, where the Ge-based layer 120 may be intentionally n-type doped (e.g., with a doping concentration of at least 1E16, 5E16, 1E17, 5E17, 1E18, 5E18, or 1E19 atoms per cubic cm) if the overlying channel material layer 130 is to be p-type doped.

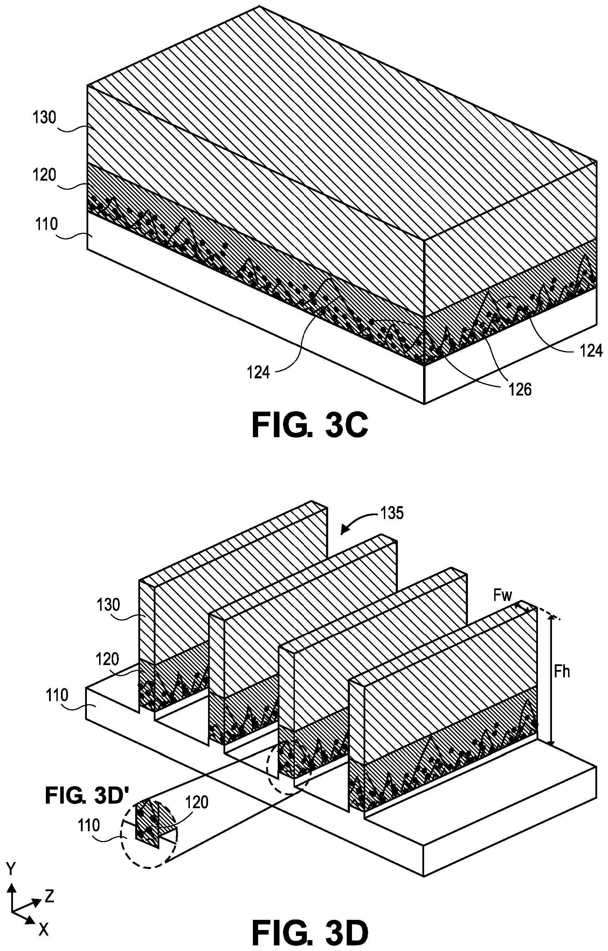

Method 200 of FIG. 2 continues at block 206 by forming channel material layer 130 on Ge-based layer 120 to thereby form the example resulting structure of FIG. 3C (which may or may not include the ions 126 shown in FIG. 3C, depending on whether the ions 126 are implanted before or after forming the channel layer 130). In some embodiments, channel material layer 130 may be formed 206 using any suitable processes, such as one of the aforementioned techniques (e.g., CVD, PVD, ALD, VPE, MBE, LPE) and/or any other suitable processing. In some embodiments, channel material layer 130 may include any suitable semiconductor material, such as monocrystalline group IV and/or group III-V semiconductor material, for example. Recall that the use of "group IV semiconductor material" (or "group IV material" or generally, "IV") herein includes at least one group IV element (e.g., silicon, germanium, carbon, tin), such as silicon (Si), germanium (Ge), silicon germanium (SiGe), and so forth. Also recall that the use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), and so forth. Note that group III may also be known as the boron group or IUPAC group 13, group IV may also be known as the carbon group or IUPAC group 14, and group V may also be known as the nitrogen family or IUPAC group 15, for example.

In some embodiments, channel material layer 130, may include at least one of silicon, germanium, gallium, arsenide, indium, and aluminum. In some embodiments, the channel material layer 130 may be doped (e.g., with any suitable n-type or p-type dopant) at a dopant concentration in the range of 1E16 to 1E22 atoms per cubic cm, for example. For example, in the case of group IV semiconductor materials, the group IV material may be p-type doped using a suitable acceptor (e.g., boron) or n-type doped using a suitable donor (e.g., phosphorous, arsenic). In another example, in the case of group III-V semiconductor material, the group III-V material may be p-type doped using a suitable acceptor (e.g., beryllium, zinc) or n-type doped using a suitable donor (e.g., silicon). In other embodiments, the channel material layer may be intrinsic/undoped (or nominally undoped, with a dopant concentration less than 1E16 atoms per cubic cm), depending on the particular configuration. Further, in some embodiments, a sacrificial channel material layer may be formed at this stage of the processing, where the sacrificial channel material layer may be later removed and replaced with final channel material layer. Such a sacrificial channel material layer may be employed in embodiments where multiple channel material layers are formed, for example. Note that although layer 130 is referred to herein as a channel material layer, transistor channel regions formed using the techniques disclosed herein may also include Ge-based layer 120 and/or other layers as can be understood based on this disclosure.

In some embodiments, channel material layer 130 may include a multilayer structure that includes two or more distinct layers (that may or may not be compositionally different). In some such embodiments, the channel material layer may be formed using a layer-by-layer epitaxial growth approach (e.g., using an MBE process), such that the channel material layer may or may not appear to have distinct interfaces within the layer, depending on the particular configuration and observation level. In embodiments where a nanowire (or nanoribbon or GAA) transistor is to be formed from the channel material layer, it may include at least one channel layer and at least one sacrificial layer to be removed to release the channel layer to enable forming that nanowire transistor, as will be described in more detail herein (e.g., with respect to FIG. 4I). For instance, in an example embodiment, a given channel material layer may include alternating layers of group IV and group III-V semiconductor material, where either the group IV or group III-V material is sacrificial, to enable the formation of one or more nanowires (e.g., where the sacrificial material is subsequently removed, such as during replacement gate processing). In some embodiments, channel material layer 130 may include grading (e.g., increasing and/or decreasing) of the concentration of one or more materials within the feature, such as the grading of a semiconductor material component concentration and/or the grading of the dopant concentration, for example. For instance, the grading may occur as the material of layer 130 is epitaxially grown (e.g., in the Y-axis direction). In some embodiments, a given channel material layer 130 may include a vertical thickness (dimension in the Y-axis direction) in the range of 20-500 nm (or in a subrange of 20-50, 20-100, 20-200, 20-300, 20-400, 50-100, 50-200, 50-300, 50-400, 50-500, 100-250, 100-400, 100-500, 200-400, or 200-500 nm) and/or a maximum vertical thickness of at most 500, 450, 400, 350, 300, 250, 200, 150, 100, or 50 nm, for example. Other suitable materials and thickness values/ranges/thresholds will be apparent in light of this disclosure.

In some embodiments, multiple different channel material layers may be formed on different areas of the Ge-based layer 120, such as for CMOS applications, for example. For instance, a first channel material layer may be formed on a first area of the Ge-based layer 120 to be used for one or more p-channel transistor devices (e.g., one or more PMOS devices) and a second channel material may be formed on a second area of the Ge-based layer 120 to be used for one or more n-channel transistor devices (e.g., one or more NMOS devices). By selecting the Ge-based layer 120 to have the desired material (e.g., the desired Ge concentration and alloying with Si, C, and/or Sn for the top surface of the Ge-based layer 120) and achieving a desired relaxation percentage, the Ge-based layer 120 can provide a template/seeding layer from which to grow the multiple different channel material layers, such that a first channel material used for p-channel transistors may have a relatively higher lattice constant or parameter value than the template surface to achieve compressive strain and a second channel material used for n-channel transistors may have a relatively lower lattice constant or parameter value than the template surface to achieve tensile strain. For instance, in some such embodiments, the first channel material layer may include SiGe or Ge such that the Ge-based layer 120 has at least 5, 10, 15, 20, 25, 30, 35, or 40% less Ge concentration by atomic percentage relative to the first channel material layer. Further, in some such embodiments, the second channel material layer may include SiGe or Si such that the Ge-based layer 120 has at least 5, 10, 15, 20, 25, 30, 35, or 40% more Ge concentration by atomic percentage relative to the second channel material layer.

In general, the top surface of Ge-based layer 120 and a given channel material layer 130 may have a difference in Ge concentration by atomic percentage in the range of 0-100%. In some embodiments employing multiple different channel material layers, the first channel material layer may include group IV semiconductor material (e.g., Si, SiGe, Ge, etc.) and the second channel material layer may include group III-V semiconductor material (e.g., GaAs, InGaAs, InP, etc.). Recall that, in general, a given channel material layer may include monocrystalline group IV semiconductor material and/or group III-V semiconductor material. For instance, in a beaded-fin transistor configuration, the channel region may include both group IV semiconductor material (e.g., for the broader or narrower portions) and group III-V semiconductor material (e.g., for the other of the broader or narrower portions). Note that the multiple different channel material layers may be formed using any suitable techniques, such as masking, depositing, and removing the masking as desired to form any number of compositionally different channel material layers. Further note that formation of multiple different channel material layers may include 2-5 or more compositionally different layers formed on the Ge-based layer 120, in accordance with some embodiments. In some embodiments, a given channel material layer 130 may be strained to the underlying Ge-based layer 120 such that the in-plane lattice parameters of the channel material layer are within 50, 45, 40, 35, 30, 25, 20, 15, 10, or 5%, or essentially the same as, the in-plane lattice parameter at/near the top surface of the Ge-based layer 120. Further, the strain may extend to essentially the top surface of the channel material layer 130, such that the channel material layer 130 is fully strained, in accordance with some embodiments. However, in other embodiments, a given channel material layer 130 may be essentially relaxed or at least relaxed in part (e.g., to within 50% of its material lattice constant). Where employed, numerous different channel material layer configurations and variations will be apparent in light of this disclosure.

Method 200 of FIG. 2 continues at block 207 by implanting ions 126 into the defective regions 124 of the relaxed buffer layer 120 and/or the substrate 110, as depicted in the example resulting structure of FIG. 3C. For example, the Ge-based layer 120 and/or the substrate 110 can be implanted with ions 126 in the defective regions to compensate for strain from the defects 124, which helps eliminate or reduce downstream wafer bowing. In this manner, the implanted ions 126 enable the use of a relatively thick Ge-based layer 120-which helps prevent the defects 124 in the Ge-based layer 120 from propagating into the channel 130-without causing downstream wafer bow. In some embodiments, the implanted ions 126 may include implanted species of carbon (C), tin (Sn), boron (B), phosphorus (P), and/or arsenic (As), among other examples.

Method 200 of FIG. 2 continues at block 208 by patterning the channel region material into fins to form the example resulting structure of FIG. 3D, in accordance with some embodiments. In some embodiments, patterning 208 may be performed using any suitable techniques, such as including one or more masking, patterning, lithography, and/or etching (e.g., wet and/or dry etching) processes, as can be understood based on this disclosure. For instance, the regions of the structure of FIG. 3C to be formed into fins may be masked off, followed by etch processing to form trenches 135 between each of the fin-shaped structures of FIG. 3D, for example. Note that the depth of the etch processing used to form the fins may vary and that such etch processing may be referred to as a shallow trench recess (STR) etch. For instance, as shown in FIG. 3D, the etch processing resulted in trenches 135 extending all the way down into substrate 110, such that each fin includes a stack, from bottom to top (in the Y-axis direction) of Si substrate 110 material, Ge-based layer 120 material, and channel material layer 130 material, in this example embodiment. However, in other embodiments, the etch processing may go farther down (e.g., such that trenches 135 may extend deeper into substrate 110) or the etch processing may not extend as far down as it did in FIG. 3D. For example, FIG. 3D' illustrates a blown-out portion of FIG. 3D showing an alternative patterning process where the etch processing stops before reaching the substrate 110/Ge-based layer 120 interface, in accordance with some embodiments. Therefore, numerous different etch levels may be used, as will be apparent in light of this disclosure.

Note that although each of the multilayer fin-shaped structures in FIG. 3D (of which there are four shown) are shown as having the same sizes and shapes relative to one another in this example structure for ease of illustration, the present disclosure is not intended to be so limited. For example, in some embodiments, the fin-shaped structures may be formed to have varying heights Fh and/or varying widths Fw that may correspond with (or be the same as) the final desired fin heights (AFh) and fin widths (Fw) described in more detail below. For instance, in some embodiments, a given Fw (dimension in the X-axis direction) may be in the range of 2-400 nm (or in a subrange of 2-10, 2-20, 2-50, 2-100, 2-200, 4-10, 4-20, 4-50, 4-100, 4-200, 4-400, 10-20, 10-50, 10-100, 10-200, 10-400, 50-100, 50-200, 50-400, or 100-400 nm), for example, or any other suitable value or range as will be apparent in light of this disclosure. Further, in some embodiments, a given Fh (dimension in the Y-axis direction) may be in the range of 4-800 nm (or in a subrange of 4-10, 4-20, 4-50, 4-100, 4-200, 4-400, 10-20, 10-50, 10-100, 10-200, 10-400, 10-800, 50-100, 50-200, 50-400, 50-800, 100-400, 100-800, or 400-800 nm), for example, or any other suitable value or range as will be apparent in light of this disclosure. In some embodiments, the fin heights Fh may be at least 25, 50, 75, 100, 125, 150, 175, 200, 300, 400, 500, 600, 700, or 800 nm tall, or greater than any other suitable threshold height as will be apparent in light of this disclosure. In some embodiments, the height to width ratio of the fins (Fh:Fw) may be greater than 1, such as greater than 1.5, 2, 2.5, 3, 3.5, 4, 4.5, 5, 6, 7, 8, 9, or 10, or greater than any other suitable threshold ratio, as will be apparent in light of this disclosure.

As previously stated, although the fins in FIG. 3D are shown as having the same heights Fh and widths Fw, the fins may be formed to have varying heights Fh, varying widths Fw, varying vertical starting points (location in the Y-axis direction), varying shapes, and/or any other suitable variation(s) as will be apparent in light of this disclosure. Moreover, trenches 135 may be formed to have varying depths, varying widths, varying vertical starting points (location in the Y-axis direction), varying shapes, and/or any other suitable variation(s) as will be apparent in light of this disclosure. Note that although four fins are shown in the example structure of FIG. 3D for ease of illustration, any number of fins may be formed, such as one, two, three, five, ten, hundreds, thousands, millions, and so forth, as can be understood based on this disclosure. Also note that the fins are shown in FIG. 3D as having a height that is relatively greater than the thickness (dimension in the Y-axis direction) of the remainder of substrate 110, for ease of illustration. However, in some embodiments, the height of the fins (shown as Fh) may be relatively much less (e.g., at least 2-10 times less) than the thickness of the remainder of substrate 110, for example.

Method 200 of FIG. 2 continues at block 210 by filling the trenches 135 between the fins of the structure of FIG. 3D with shallow trench isolation (STI) material 140, thereby forming the example resulting structure of FIG. 4E, in accordance with some embodiments. Such processing can include depositing the STI material and then optionally planarizing/polishing the structure (e.g., via CMP) to form the example structure of FIG. 4E, for example. In some embodiments, deposition of the STI material 140 may include any suitable deposition techniques, such as those described herein (e.g., CVD, ALD, PVD), or any other suitable deposition process. In some embodiments, STI material 140 (which may be referred to as an STI layer or STI regions) may include any suitable electrical insulator material, such as one or more dielectric, oxide (e.g., silicon dioxide), and/or nitride (e.g., silicon nitride) materials. In some embodiments, the material of STI layer 140 may be selected based on the material of substrate 110. For instance, the STI material may be selected from silicon dioxide or silicon nitride based on the use of a Si substrate 110, to provide some examples.

Method 200 of FIG. 2 may include an alternative replacement fin-based approach 211 for processes 202-210 to arrive at the structure of FIG. 4E, in accordance with some embodiments. For instance, FIGS. 4A-E illustrate example structures formed when carrying out the alternative replacement fin-based approach 211. Note that the previous relevant description with respect to processes 202-210 and the structures of FIGS. 3A-D and 4E formed therefrom is equally applicable to the alternative replacement fin-based process 211 and the structures of FIGS. 4A-E. As can be understood based on this disclosure, the replacement fin-based approach includes forming fins from the substrate, forming STI material around those fins, recessing the native-to-substrate fins to form fin-shaped trenches, and then forming replacement fins in the fin-shaped trenches. Such a replacement fin-based approach 211 to forming the structure of FIG. 4A can include providing a substrate 110 as shown in FIG. 4A. The previous relevant description with respect to substrate 110 is equally applicable here.

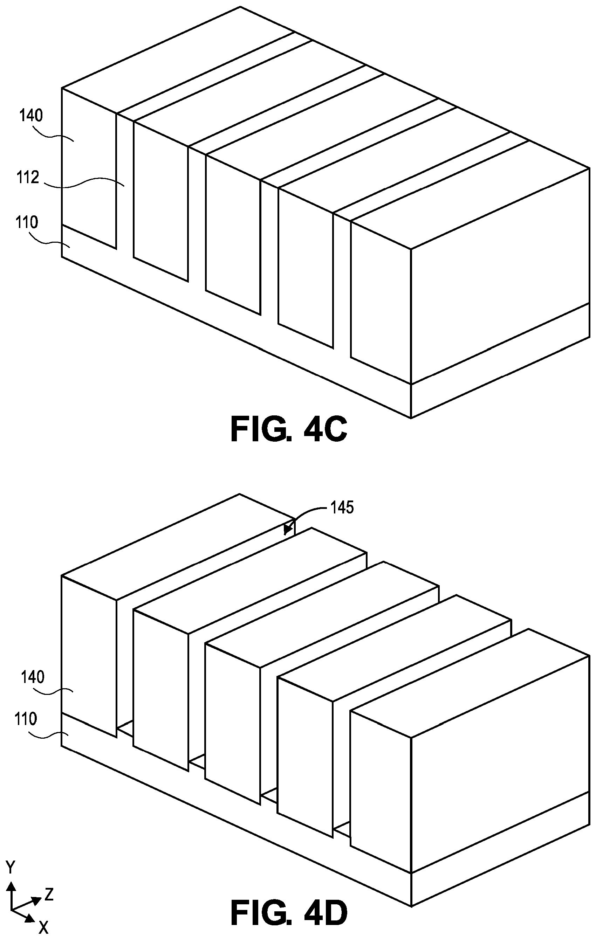

Replacement fin-based approach 211 continues with forming fins 112 from substrate 110 to form the example resulting structure of FIG. 4B. The previous relevant description with respect to the fins of FIG. 3D are equally applicable here, except that the fins 112 in FIG. 4B only include material native to substrate 110. Further, the previous relevant description with respect to trenches 135 is equally applicable to the trenches 115 between fins 112. Approach 211 continues with forming STI material 140 between the fins 112 to form the example resulting structure of FIG. 4C. The previous relevant description with respect to STI material 140 is equally applicable here. Approach 211 continues with recessing fins 112 to form fin-shaped trenches 145 in the example resulting structure of FIG. 4D. The recessing can be performed using any suitable techniques, such as wet and/or dry etch processing. Approach 211 continues by forming layers 120 and 130 (e.g., via deposition/epitaxial growth techniques) in trenches 145, and by implanting ions 126 among the defects 124 that form at or near the interface of layers 110 and 120, to arrive at the example resulting structure of FIG. 4E. The previous relevant description with respect to layers 120 and 130 and the implanted ions 126 is equally applicable here, except that the layers are formed using a replacement fin-based approach 211 in this example embodiment as compared to the previously described blanket deposition approach.

Regardless of whether a blanket deposition approach (e.g., using processes 202-210) or a replacement fin-based approach (such as approach 211 described above) is used to form the structure of FIG. 4E, method 200 of FIG. 2 can continue to block 212 which includes optionally recessing the STI material 140 to a desired level to form the example resulting structure of FIG. 4F, in accordance with some embodiments. Note that in some embodiments, recess 212 is optional and need not be performed, such as for transistors employing planar configurations, for example. For instance, in some such embodiments, transistors may be formed using the top surface of channel material layer 130, as can be understood based on this disclosure. However, in the example embodiment of FIG. 4F, STI material 140 was recessed to allow a portion of the original fins to exude above the top surface of STI material 140 as shown. In some embodiments, recessing 212, where performed, may include any suitable techniques, such as using one or more wet and/or dry etch processes that allow the STI material 140 to be selectively recessed relative to the fin material, and/or any other suitable processing as will be apparent in light of this disclosure.

In the example embodiment of FIG. 4F, the STI material 140 was recessed such that only the entirety of the channel material layer 130 portion of the fins is above the top surface of the STI material 140, as shown. Thus, the top plane of the STI material 140 is at the same level as the interface between the Ge-based layer 120 and the channel material layer 130, in this example case. As can be understood based on this disclosure, that portion of the fin that exudes above the top plane/surface of the STI material 140 may be used in the active channel region of one or more transistors, such that those fin portions may be referred to as active fin portions herein, for example. Moreover, the remaining portions of the fins extending from substrate 110 and below the top plane of STI layer 140 may be referred to as sub-fin or sub-channel portions, for example, as that structure will be below the channel region of the subsequently formed transistor devices, in at least one IC orientation. FIG. 4F' illustrates a blown-out portion of FIG. 4F showing an alternative STI material 140 recess location, in accordance with some embodiments. As shown in FIG. 4F', the recess resulted in the top surface of the STI material 140 being below the interface between the Ge-based layer 120 and the channel material layer 130, such that a top portion of Ge-based layer 120 would be a part of the active fin height, as can be understood based on this disclosure.

Generally, the active fin height, indicated as AFh, may be in the range of 4-800 nm (e.g., in the subrange of 4-10, 4-20, 4-50, 4-100, 4-200, 4-400, 10-20, 10-50, 10-100, 10-200, 10-400, 10-800, 50-100, 50-200, 50-400, 50-800, 100-400, 100-800, or 400-800 nm), for example, or any other suitable value or range, as will be apparent in light of this disclosure. In some embodiments, the active fin heights AFh may be at least 25, 50, 75, 100, 125, 150, 175, 200, 300, 400, 500, 600, 700, or 800 nm tall, or greater than any other suitable threshold height as will be apparent in light of this disclosure. The previous relevant description with respect to fin width Fw is equally applicable to the active fin width (which is also indicated as Fw, as it did not change). As can be understood based on this disclosure, the active fin height is the portion of the original fins formed on substrate 110 that will be included in a transistor channel region, while the remainder of the fin, which is the portion below that active fin height, is referred to as a sub-fin or sub-channel portion. Numerous different active channel regions may be formed as will be apparent in light of this disclosure.

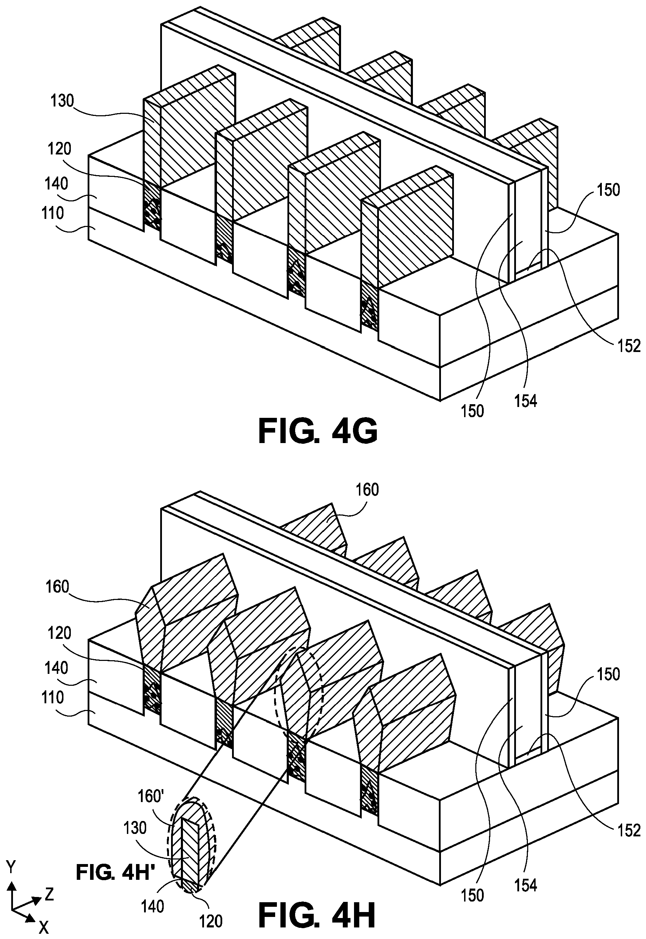

Method 200 of FIG. 2 continues at block 214 by forming the dummy or final gate stack in accordance with some embodiments. As previously described, a gate last fabrication process may utilize a dummy gate stack to allow for replacement gate processing, while a gate first fabrication process may form the final gate stack in the first instance. Continuing from the example structure of FIG. 4F, the processing is primarily described herein in the context of a gate last transistor fabrication flow, where the processing includes forming a dummy gate stack, performing the S/D processing, and then forming the final gate stack after the S/D regions have been processed. In other embodiments, the techniques may be performed using a gate first process flow. In such example embodiments, a dummy gate stack need not be formed, as the final gate stack can be formed in the first instance. However, the description of the continued processing will be described using a gate last process flow, to allow for such a gate last flow (which may include additional processing) to be adequately described. Regardless, the end structure of either a gate first or a gate last process flow will include the final gate stack, as will be apparent in light of this disclosure. In this example embodiment, the processing includes forming a dummy gate stack (which includes dummy gate dielectric 152 and dummy gate electrode 154) on the structure of FIG. 4F, thereby forming the example resulting structure of FIG. 4G, in accordance with some embodiments. Recall, the formation of the dummy gate stack is optional, because it need not be performed in all embodiments (such as those employing a gate first process flow). In this example embodiment, dummy gate dielectric 152 (e.g., dummy oxide material) and dummy gate electrode 154 (e.g., dummy poly-silicon material) may be used for a replacement gate process. Note that side-wall spacers 150, referred to generally as gate spacers (or simply, spacers), on either side of the dummy gate stack were also formed, and such spacers 150 can help determine the channel length and/or help with replacement gate processing, for example.

As can be understood based on this disclosure, the dummy gate stack (and spacers 150) help define the channel region and source/drain (S/D) regions of each fin, where the channel region is below the dummy gate stack (as it will be located below the final gate stack), and the S/D regions are on either side of and adjacent the channel region. Note that because the IC structures are being described in the context of forming finned transistors, the final gate stack will also be adjacent to either side of the fin, as the gate stack will reside along three walls of the finned channel regions and/or wrap around the active fin portion from one region of STI material 140 to another region of STI material, in some such embodiments. Formation of the dummy gate stack may include depositing the dummy gate dielectric material 152 and dummy gate electrode material 154, patterning the dummy gate stack, depositing gate spacer material 150, and performing a spacer etch to form the structure shown in FIG. 4G, for example. Spacers 150 may include any suitable material, such as any suitable electrical insulator, dielectric, oxide (e.g., silicon oxide), and/or nitride (e.g., silicon nitride) material, as will be apparent in light of this disclosure. Note that in some embodiments, a hardmask (not shown) may be formed over the dummy gate stack (which may or may not also be formed over spacers 150) to protect the dummy gate stack during subsequent processing, for example.

Method 200 of FIG. 2 continues at block 216 by performing source and drain (S/D) region processing to form the example resulting structure of FIG. 4H, in accordance with some embodiments. The S/D regions 160, in some embodiments, may be formed using any suitable techniques, such as masking regions outside of the S/D regions to be processed, etching at least a portion of the exposed fins from the structure of FIG. 4G, and forming/depositing/growing the S/D regions 160 (e.g., using any suitable techniques, such as CVD, PVD, ALD, VPE, MBE, LPE), for example. However, in some embodiments, the exposed fins (which in the embodiment of FIG. 4G includes channel material layer 130) need not be completely removed, but they may remain (at least in part) in the final S/D regions and be doped, implanted, and/or clad with final S/D material and/or have any other suitable processing performed to convert them into suitable final S/D regions, for example. For instance, FIG. 4H' illustrates a blown-out portion of FIG. 4H showing an S/D region formed using a cladding scheme, in accordance with some embodiments. As shown in FIG. 4H', the final S/D material 160' was formed on the original exposed fin in that S/D location (which included channel material layer 130). In the example embodiment of FIG. 4H, as the material of the S/D regions 160 is replacement material, there is a distinct interface between the underlying sub-fin portions and S/D regions 160, as shown in FIG. 4H. In some embodiments, one or more of the S/D regions 160 may have a multilayer structure including two or more distinct layers, for example. For instance, in FFFET configurations, the source region has a bi-layer structure that includes two oppositely doped layers (e.g., one is n-type doped and the other is p-type doped), for example. In some embodiments, one or more of the S/D regions 160 may include grading (e.g., increasing and/or decreasing) the content/concentration of one or more materials in some or all of the region(s). For instance, in some embodiments, it may be desired to increase the grading as a given S/D region 160 is formed, to have a relatively lower doping concentration near the channel region and a relatively higher doping concentration near the corresponding S/D contact.

In some embodiments, the S/D regions 160 may be formed one polarity at a time, such as performing processing for one of n-type and p-type S/D regions, and then performing processing for the other of the n-type and p-type S/D regions. In some embodiments, the S/D regions may include any suitable material, such as monocrystalline group IV and/or group III-V semiconductor material and/or any other suitable semiconductor material, as will be apparent in light of this disclosure. In some embodiments, the S/D regions corresponding to a given channel region may include the same group of semiconductor material as what is included in the given channel region, such that if the given channel region includes group IV semiconductor material, the corresponding S/D regions may also include group IV semiconductor material (whether the same IV material or different); however, the present disclosure is not intended to be so limited. In some embodiments, the S/D regions may include any suitable doping scheme, such as including suitable n-type and/or p-type dopant (e.g., in a concentration in the range of 1E16 to 1E22 atoms per cubic cm). However, in some embodiments, at least one S/D region 160 may be undoped/intrinsic or relatively minimally doped, such as including a dopant concentration of less than 1E16 atoms per cubic cm, for example.

To provide some example configurations, in embodiments where corresponding S/D regions on either side of a given channel region are to be used for a MOSFET device, the S/D regions may include the same type of dopants (e.g., where both are p-type doped or both are n-type doped). Specifically, for an NMOS device, the included S/D regions include semiconductor material that is n-type doped, and for a PMOS device, the included S/D regions include semiconductor material that is p-type doped, in some embodiments. Whereas for a TFET device, the S/D regions for a given channel region may be oppositely doped, such that one is p-type doped and the other is n-type doped, in some embodiments. Note that for ease of illustration and description, all S/D regions are shown as being the same and are identified collectively by numeral 160. However, in some embodiments, the S/D regions 160 may include differing materials, dopant schemes, shapes, sizes, corresponding channel regions (e.g., 1, 2, 3, or more), and/or any other suitable difference as can be understood based on this disclosure. For instance, the S/D regions 160 of FIG. 4H includes pentagon or diamond-like shape (as viewed in the X-Y plane), while the S/D region 160' of FIG. 4H' includes a rounded or curved hill-like shape (as viewed in the X-Y plane), to provide a few examples. Further note that the shading or patterning of the features/layers of the IC structures included in FIGS. 3A-D, 4A-J, and 6 is provided merely to assist in visually distinguishing those different IC features/layers. Such shading or patterning is not intended to limit the present disclosure in any manner. Numerous transistor S/D configurations and variations will be apparent in light of this disclosure.

In some embodiments, for example, a layer of isolation material (not shown) may be included between the S/D regions 160 and the relaxed buffer layer 120, which prevents or reduces leakage between the source and drain regions 160 through the relaxed buffer layer 120 or the substrate 110. The isolation material can include an oxide, such as aluminum oxide (e.g., Al₂O₃) or silicon oxide (e.g., SiO₂), a nitride (e.g., Si₃N₄), a low-k dielectric (e.g., porous SiO₂ or material having a dielectric constant below 3.9), an oxynitride compound, such as aluminum oxynitride (e.g., (AlN)ₓ-(Al₂O₃)₁₋ₓ), carbon oxynitride (-CNO), and/or another oxynitride compound (-NO), and/or any other suitable electrically insulating material.

Method 200 of FIG. 2 continues at block 218 by performing the final gate stack processing to form the example resulting structure of FIG. 4I, in accordance with some embodiments. As shown in FIG. 4I, the processing in this example embodiment included depositing interlayer dielectric (ILD) material 170 on the structure of FIG. 4H, followed by optional planarization and/or polishing (e.g., CMP) to reveal the dummy gate stack. Note that the ILD material 170 is shown as transparent in the example structure of FIG. 4H to allow for the underlying features to be seen (and the ILD material 170 may actually be transparent or translucent at such a small scale); however, the present disclosure is not intended to be so limited. Also note that the ILD layer 170 may include a multilayer structure, even though it is illustrated as a single layer. Further note that in some cases, ILD material 170 and STI material 140 may not include a distinct interface as shown in FIG. 4H, particularly where, e.g., the ILD layer 170 and STI material 140 include the same dielectric material. In some embodiments, the ILD layer 170 may include any suitable material, such as one or more oxides (e.g., silicon oxide), nitrides (e.g., silicon nitride), dielectrics, and/or electrically insulating material, for example.

The gate stack processing, in this example embodiment, continued with removing the dummy gate stack (including dummy gate electrode 154 and dummy gate dielectric 152) to allow for the final gate stack to be formed. Recall that in some embodiments, the formation of the final gate stack, which includes gate dielectric 182 and gate electrode 184, may be performed using a gate first fabrication flow (e.g., an up-front hi-k gate process). In such embodiments, the final gate processing may have been performed prior to the S/D processing, for example. Further, in such embodiments, process 218 need not be performed, as the final gate stack would have been formed at block 214, for example. However, in this example embodiment, the gate stack is formed using a gate last fabrication flow, which may also be considered a replacement gate or replacement metal gate (RMG) process. In such gate last processing, the process may include dummy gate oxide deposition, dummy gate electrode (e.g., poly-Si) deposition, and, optionally, patterning hardmask deposition, as previously described. Regardless of whether gate first or gate last processing is employed, the final gate stack can include gate dielectric 182 and gate electrode 184 as shown in FIG. 4H and described herein, in accordance with some embodiments.

Note that when the dummy gate is removed, the channel regions of the previously formed fins (which include channel material layer 130, in this example case) that were covered by the dummy gate are exposed to allow for any desired processing of those channel regions of the fins. Such processing of the channel regions may include various different techniques, such as removing and replacing the channel region with replacement material, doping the channel region of the fin as desired, forming the fin into one or more nanowires (or nanoribbons) for a gate-all-around (GAA) transistor configuration, forming the fin into a beaded-fin configuration, cleaning/polishing the channel region, and/or any other suitable processing as will be apparent in light of this disclosure. For instance, finned channel regions 130 and 132 are illustrated (which are the channel regions of the right-most finned structure and the second-from-the-right finned structure, respectively), where finned channel region 130 includes the channel material layer (and in other embodiments, may include at least a portion of the Ge-based layer 120, such as in the case of the structure of FIG. 4F') and the second finned channel region 132 may include any other suitable configuration. For instance, in some embodiments, second finned channel region 132 may include a second channel material layer that is compositionally different from the first channel material layer 130, to provide some examples. Thus, and as was previously described, finned channel region 130 may be used for an n-channel or p-channel finned transistor device, while second finned channel region 132 may be used for the other of an n-channel or p-channel finned transistor device, in accordance with an example embodiment. Further, in such an example embodiment, both of the finned channel regions 130 and 132 may be included in a complementary transistor circuit (e.g., a CMOS circuit), for instance.

Other non-planar transistor configurations (that is, other than finned configurations, which may utilize a tri-gate or double-gate scheme) are also shown in the example structure of FIG. 4I. For instance, nanowire channel region 136 may have been formed after the dummy gate stack was removed and the channel regions were exposed, by converting an original finned structure at that location into the nanowires 136 shown using, for example, any suitable techniques. For instance, the original finned channel region may have included a multilayer structure, where one or more of the layers were sacrificial and selective etch processing was performed to remove those sacrificial layers and release the nanowires 136. As shown in FIG. 4I, nanowire channel region 136 includes 2 nanowires (or nanoribbons) in this example case. However, a nanowire (or nanoribbon or GAA) transistor formed using the techniques disclosed herein may include any number of nanowires (or nanoribbons) such as 1, 3, 4, 5, 6, 7, 8, 9, 10, or more, depending on the desired configuration. In some embodiments, a nanowire or nanoribbon may be considered fin-shaped where the gate stack wraps around each fin-shaped nanowire or nanoribbon in a GAA transistor configuration. To provide yet another example non-planar transistor configuration, beaded-fin channel region 134 is a hybrid between a finned channel region and a nanowire channel region, where the sacrificial material (shown with grey shading) that may have been completely removed to release nanowires was instead only partially removed to form the resulting beaded-fin structure 134 shown. Such a beaded-fin channel region structure may benefit from, for instance, increased gate control (e.g., compared to a finned channel region structure) while also having, for instance, relatively reduced parasitic capacitance (e.g., compared to a nanowire channel region structure). Therefore, numerous different channel region configurations can be employed using the techniques described herein, including planar and a multitude of non-planar configurations.

As can be understood based on this disclosure, the channel region may be at least below the gate stack, in some embodiments. For instance, in the case of a planar transistor configuration, the channel region may just be below the gate stack. However, in the case of a finned transistor configuration, the channel region may be below and between the gate stack, as the gate stack may be formed on three sides of the finned structure (e.g., in a tri-gate manner), as is known in the art. Further, in the case of a nanowire (or nanoribbon or GAA) transistor configuration, the gate stack may substantially (or completely) surround each nanowire/nanoribbon in the channel region (e.g., wrap around at least 80, 85, 90, or 95% of each nanowire/nanoribbon). Regardless, in some embodiments, the gate of a transistor may be proximate to the channel region of that transistor. Generally, in some embodiments, the channel region may include any suitable material, such as monocrystalline group IV and/or group III-V semiconductor material, for example. In some embodiments, the channel region of a given transistor may be doped (e.g., with any suitable n-type and/or p-type dopants) or intrinsic/undoped, depending on the particular configuration. Note that S/D regions 160 are adjacent to either side of a given channel region, as can be seen in FIG. 4I. In other words, each channel region is between corresponding S/D regions 160. Also note that the configuration/geometry of a transistor formed using the techniques described herein may primarily be described based on the shape/configuration of the respective channel region of that transistor, for example. For instance, a nanowire (or nanoribbon or GAA) transistor may be referred to as such because it includes one or more nanowires (or nanoribbons) in the channel region of that transistor, but the S/D regions need not include such a nanowire (or nanoribbon) shape.

Continuing with the example structure of FIG. 4I, after the dummy gate has been removed and any desired channel region processing has been performed, the final gate stack can be formed, in accordance with some embodiments. In this example embodiment, the final gate stack includes gate dielectric 182 and gate electrode 184, as shown in FIG. 4I. The gate dielectric 182 may include, for example, any suitable oxide (such as silicon dioxide), high-k dielectric material, and/or any other suitable material as will be apparent in light of this disclosure. Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. In some embodiments, an annealing process may be carried out on the gate dielectric 182 to improve its quality when high-k dielectric material is used. The gate electrode 184 may include a wide range of materials, such as polysilicon or various suitable metals or metal alloys, such as aluminum (Al), tungsten (W), titanium (Ti), tantalum (Ta), copper (Cu), titanium nitride (TiN), or tantalum nitride (TaN), for example.

In some embodiments, gate dielectric 182 and/or gate electrode 184 may include a multilayer structure of two or more material layers, for example. For instance, in some embodiments, a multilayer gate dielectric may be employed to provide a more gradual electric transition from the channel region to the gate electrode, for example. In some embodiments, gate dielectric 182 and/or gate electrode 184 may include grading (e.g., increasing and/or decreasing) the content/concentration of one or more materials in at least a portion of the feature(s). One or more additional layers may also be present in the final gate stack, in some embodiments, such as one or more relatively high or low work function layers and/or other suitable layers, for example. Note that although gate dielectric 182 is only shown below gate electrode 184 in the example embodiment of FIG. 4I, in other embodiments, the gate dielectric 182 may also be present on one or both sides of gate electrode 184, such that the gate dielectric 182 is between gate electrode 184 and one or both spacers 150, for example. Numerous different gate stack configurations will be apparent in light of this disclosure.

Method 200 of FIG. 2 continues at block 220 by performing S/D contact processing to form the example resulting structure of FIG. 4J, in accordance with some embodiments. As shown in FIG. 4J, S/D contacts 190 were formed to make contact to each of the S/D regions 160, in this example embodiment. In some embodiments, S/D contacts 190 may be formed using any suitable techniques, such as forming contact trenches in ILD layer 170 over the respective S/D regions 160 and depositing metal or metal alloy (or other suitable electrically conductive material) in the trenches. In some embodiments, S/D contact 190 formation may include silicidation, germanidation, III-V-idation, and/or annealing processes, for example. In some embodiments, S/D contacts 190 may include aluminum or tungsten, although any suitable conductive metal or alloy can be used, such as silver, nickel-platinum, or nickel-aluminum, for example. In some embodiments, one or more of the S/D contacts 190 may include a resistance reducing metal and a contact plug metal, or just a contact plug, for instance. Example contact resistance reducing metals include, for instance, nickel, aluminum, titanium, gold, gold-germanium, nickel-platinum, nickel aluminum, and/or other such resistance reducing metals or alloys. Example contact plug metals include, for instance, aluminum, copper, nickel, platinum, titanium, or tungsten, or alloys thereof, although any suitably conductive contact metal or alloy may be used. In some embodiments, additional layers may be present in the S/D contact 190 regions, such as adhesion layers (e.g., titanium nitride) and/or liner or barrier layers (e.g., tantalum nitride), if so desired. In some embodiments, a contact resistance reducing layer may be present between a given S/D region 160 and its corresponding S/D contact 190, such as a relatively highly doped (e.g., with dopant concentrations greater than 1E18, 1E19, 1E20, 1E21, or 1E22 atoms per cubic cm) intervening semiconductor material layer, for example. In some such embodiments, the contact resistance reducing layer may include semiconductor material and/or impurity dopants based on the included material and/or dopant concentration of the corresponding S/D region, for example.

Method 200 of FIG. 2 continues at block 222 by completing general integrated circuit (IC) processing as desired, in accordance with some embodiments. Such additional processing to complete an IC may include back-end or back-end-of-line (BEOL) processing to form one or more metallization layers and/or to interconnect the transistor devices formed, for example. Any other suitable processing may be performed, as will be apparent in light of this disclosure. Note that the processes 202-222 in method 200 of FIG. 2 are shown in a particular order for ease of description. However, one or more of the processes may be performed in a different order or may not be performed at all (and thus be optional), in accordance with some embodiments. For example, processes 212 and 218 may be optional in some embodiments, as previously described. Further, processes 202-210 may be alternatively performed using a replacement fin-based approach 211, in accordance with some embodiments. Numerous variations on method 200 and the techniques described herein will be apparent in light of this disclosure.

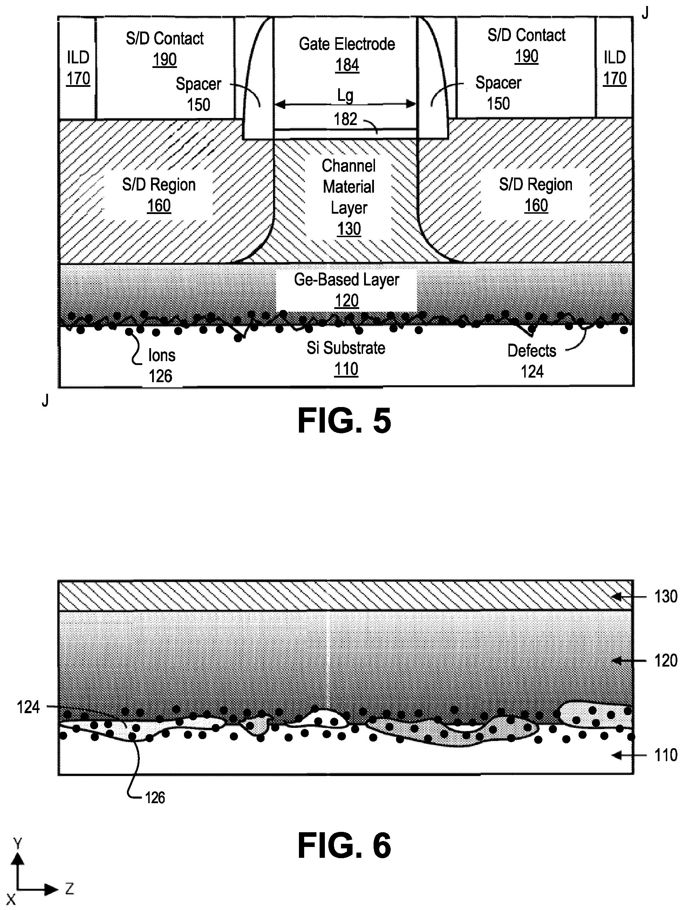

FIG. 5 illustrates an example cross-sectional view taken along the plane J-J in FIG. 4J, in accordance with some embodiments of the present disclosure. The cross-sectional view of FIG. 5 is provided to assist in illustrating different features of the structure of FIG. 4J, for example. Therefore, the previous relevant description with respect to the each similarly numbered feature is equally applicable to FIG. 5. However, note that the dimensions of the features shown in FIG. 5 may differ in some ways (relative to the features in the structure of FIG. 4J), for ease of illustration. Also note that some variations occur between the structures, such as the shape of spacers 150 and of the finned channel region (which includes channel material layer 130, in the example embodiments), for instance. In some embodiments, the length of gate electrode 184 (e.g., the dimension between spacers 150 in the Z-axis direction), which is indicated as Lg, may be any suitable length as can be understood based on this disclosure. For instance, in some embodiments, the gate length may be in the range of 3-100 nm (e.g., 3-10, 3-20, 3-30, 3-50, 5-10, 5-20, 5-30, 5-50, 5-100, 10-20, 10-30, 10-50, 10-100, 20-30, 20-50, 20-100, or 50-100 nm), or any other suitable value or range as will be apparent in light of this disclosure. In some embodiments, the gate length may be less than a given threshold, such as less than 100, 50, 40, 30, 25, 20, 15, 10, 8, or 5 nm, or less than any other suitable threshold as will be apparent in light of this disclosure. For instance, in some embodiments, the gate length may be the same as or similar to the channel length (e.g., the gate length may be approximately longer than the channel length, such as 1-20% longer, due to potential diffusion of dopant from the S/D regions into the channel region and/or due to the use of S/D region tips that extend under the gate stack), which may also be any suitable length as can also be understood based on this disclosure. In some embodiments, the techniques enable maintaining a desired device performance when scaling to such low thresholds, such as sub-50, sub-40, sub-30, or sub-20 nm thresholds, as can be understood based on this disclosure.

FIG. 6 is a schematic of a transmission electron microscopy (TEM) image showing an example stack of layers including Si substrate 110, Ge-based layer 120, and channel material layer 130 to illustrate defects 124 nucleating at the substrate 110/Ge-based layer 120 interface, along with ions 126 implanted among the defects 124, in accordance with some embodiments. The 110/120/130 stack of layers is also shown in FIG. 3C, for example. As was previously stated, in the IC stack of layers described herein, relaxation of the Ge-based layer 120, including the inverse-graded nature and/or relatively high Ge concentration at the bottom of the Ge-based layer 120, causes the formation of defects (e.g., dislocations and/or stacking faults) that are predominantly contained within the Ge-based layer 120 rather than running through to layer 130. In some cases, the defects 124 may propagate from the 110/120 interface toward the Si substrate 110 and/or toward the Ge-based layer 120, such that the defects may be considered to be in the Si substrate and/or in the Ge-based layer 120, for example. The defects 124 may create nooks, crannies, voids, valleys, material separations, and/or other such features at the interface between the Si substrate 110 and the Ge-based layer 120, for example. As such, that 110/120 interface may not be readily apparent, but may instead primarily appear as the defects 124 that it helps create. Moreover, to compensate for the strain produced by these defects 124, ions 126 are implanted in the defective regions 124 of the Ge-based layer 120 and/or the substrate 110, which helps to prevent or reduce wafer bow during downstream processing. Therefore, in some embodiments, the techniques described herein may be identified based on the presence of defects 124 that are at least in part (or primarily) trapped or contained near the interface between the Si substrate 110 and the Ge-based layer 120, along with the presence of ions 126 implanted among, throughout, and/or around those defects 124.

In some embodiments, the top portion/surface of the Ge-based layer 120 may have a relatively low defect or dislocation density, such as less than 1E9 per square cm, which is the typical minimum threshold defect/dislocation density that would form at the top portion/surface of the Ge-based layer 120 if inverse grading of the Ge concentration within the layer were not employed. In some such embodiments, the top portion/surface of the Ge-based layer 120 may have a defect/dislocation density of at most 1E9, 5E8, 1E8, 5E7, 1E7, 5E6, 1E6, 5E5, 1E5, 5E4, or 1E4 per square cm, for example. In some embodiments, the top portion/surface of the Ge-based layer 120 may include essentially no defects or dislocations, as they may terminate prior to reaching that top portion/surface. As can be understood based on this disclosure, the techniques described herein for forming a relaxed Ge-based layer 120 allows for the formation of a multitude of different transistor types/configurations/architectures, with various different materials that may or may not be strained. Further, in some embodiments that employ multiple transistor devices (e.g., CMOS circuits), layers 120 and 130 can either all be the same between the multiple transistor devices, or one or both of the layers may be different (e.g., different between NMOS devices and PMOS devices). Numerous variations and configurations will be apparent in light of this disclosure.

### Example System

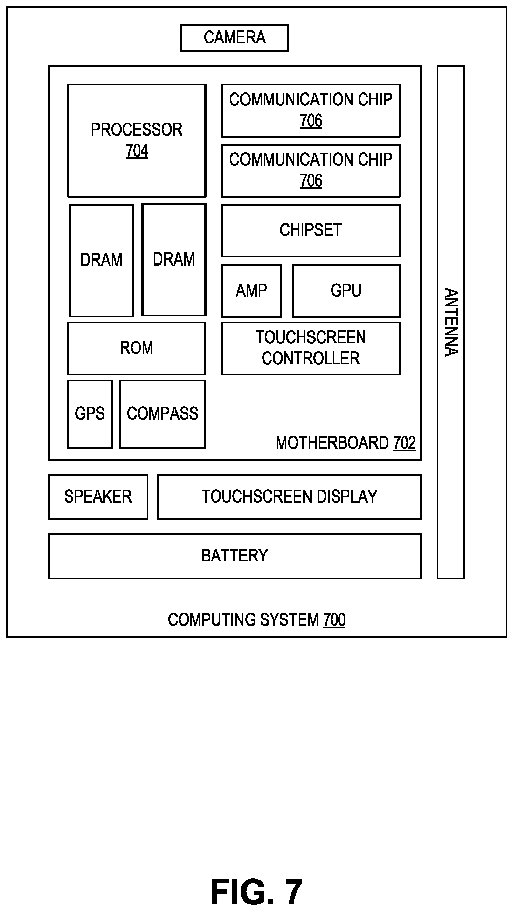

FIG. 7 illustrates a computing system 700 implemented with integrated circuit structures and/or transistor devices formed using the techniques disclosed herein, in accordance with some embodiments. As can be seen, the computing system 700 houses a motherboard 702. The motherboard 702 may include a number of components, including, but not limited to, a processor 704 and at least one communication chip 706, each of which can be physically and electrically coupled to the motherboard 702, or otherwise integrated therein. As will be appreciated, the motherboard 702 may be, for example, any printed circuit board, whether a main board, a daughterboard mounted on a main board, or the only board of system 700, etc.

Depending on its applications, computing system 700 may include one or more other components that may or may not be physically and electrically coupled to the motherboard 702. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 700 may include one or more integrated circuit structures or devices formed using the disclosed techniques in accordance with an example embodiment. In some embodiments, multiple functions can be integrated into one or more chips (e.g., for instance, note that the communication chip 706 can be part of or otherwise integrated into the processor 704).

The communication chip 706 enables wired and/or wireless communications for the transfer of data to and from the computing system 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing system 700 includes an integrated circuit die packaged within the processor 704. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 706 also may include an integrated circuit die packaged within the communication chip 706. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 704 (e.g., where functionality of any chips 706 is integrated into processor 704, rather than having separate communication chips). Further note that processor 704 may be a chip set having such wireless capability. In short, any number of processor 704 and/or communication chips 706 can be used. Likewise, any one chip or chip set can have multiple functions integrated therein.

In various implementations, the computing system 700 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

## Claims

1. An integrated circuit device, comprising:
a substrate (110) comprising silicon;
a buffer layer (120) above the substrate (110), wherein the buffer layer (120) has a plurality of defects (124) near an interface of the buffer layer (120) and the substrate (110), and wherein the buffer layer (120) comprises:
a first semiconductor material; and
a plurality of ions (126), wherein the plurality of ions (126) are implanted among the plurality of defects (124);
a source region (160, 162) above the buffer layer (120);
a drain region (160, 162) above the buffer layer (120);
a channel region (130, 132) above the buffer layer (120) and between the source region (160, 162) and the drain region (160, 162), wherein the channel region (130, 132) comprises a second semiconductor material; and
a gate structure (184) above the channel region (130, 132);
**characterized in that** the buffer layer (120) is a Ge-based layer comprising a concentration of germanium decreasing from the interface of the buffer layer (120) and the substrate (110) in a step-wise manner.

2. The integrated circuit device of Claim 1, wherein:
the buffer layer (120) has a relaxed lattice constant relative to the substrate (110); and
the channel region (130, 132) has a strained lattice constant relative to the buffer layer (120).

3. The integrated circuit device of any of Claims 1-2, wherein:
The channel region (130, 132) is tensile strained relative to the buffer layer (120); or
the channel region (130, 132) is compressive strained relative to the buffer layer (120).

4. The integrated circuit device of any of Claims 1-3, wherein:
the first semiconductor material comprises a first group IV semiconductor material; and
the second semiconductor material comprises a second group IV semiconductor material.

5. The integrated circuit device of Claim 4, wherein:
the first group IV semiconductor material comprises silicon and germanium; and
the second group IV semiconductor material comprises silicon, germanium, or tin.

6. The integrated circuit device of any of Claims 1-3, wherein the second semiconductor material comprises a second group III-V semiconductor material.

7. The integrated circuit device of Claim 6, wherein the second group III-V semiconductor material comprises indium, gallium, aluminum, arsenic, or antimony.

8. The integrated circuit device of any of Claims 1-7, wherein at least some of the plurality of ions (126) comprise carbon, tin, boron, phosphorus, or arsenic.

9. The integrated circuit device of any of Claims 1-8, wherein the buffer layer (120) has a thickness of at least 500 nanometers.

10. The integrated circuit device of any of Claims 1-9, wherein the channel region (130, 132) is one of n-type or p-type doped and the buffer layer (120) is the other of n-type or p-type doped relative to the channel region (130, 132).

11. The integrated circuit device of any of Claims 1-10, further comprising:
processing circuitry;
memory circuitry; and
communication circuitry;
wherein the processing circuitry, the memory circuitry, or the communication circuitry comprises an integrated circuit die, wherein the integrated circuit die comprises the substrate, the buffer layer, the source region, the drain region, the channel region, and the gate structure.

12. The integrated circuit device of any of Claims 1-11, wherein:
the source region (160, 162) comprises a plurality of source regions;
the drain region (160, 162) comprises a plurality of drain regions;
the channel region (130, 132) comprises a plurality of channel regions;
the gate structure (184) comprises a plurality of gate structures; and
the integrated circuit device further comprises a plurality of transistors above the buffer layer (120), wherein individual transistors comprise:
a corresponding source region from the plurality of source regions;
a corresponding drain region from the plurality of drain regions;
a corresponding channel region from the plurality of channel regions; and
a corresponding gate structure from the plurality of gate structures.

13. The integrated circuit device of Claim 12, further comprising a complementary metal-oxide-semiconductor, CMOS, circuit, wherein the CMOS circuit comprises the plurality of transistors, and wherein the plurality of transistors comprises:
an n-channel transistor, wherein the n-channel transistor has tensile strain in the corresponding channel region; and
a p-channel transistor, wherein the p-channel transistor has compressive strain in the corresponding channel region.

14. A method of forming the integrated circuit device as claimed in any preceding claim.

## Patentansprüche

1. Integrierte Schaltungsvorrichtung, umfassend:
ein Substrat (110), das Silizium enthält;
eine Pufferschicht (120) über dem Substrat (110), wobei die Pufferschicht (120) mehrere Defekte (124) in der Nähe einer Grenzfläche zwischen der Pufferschicht (120) und dem Substrat (110) aufweist und wobei die Pufferschicht (120) Folgendes umfasst:
ein erstes Halbleitermaterial; und
mehrere Ionen (126), wobei die mehreren Ionen (126) unter den mehreren Defekten (124) implantiert sind;
ein Source-Gebiet (160, 162) über der Pufferschicht (120);
ein Drain-Gebiet (160, 162) über der Pufferschicht (120); Ein Kanalgebiet (130, 132) oberhalb der Pufferschicht (120) und zwischen dem Source-Gebiet (160, 162) und dem Drain-Gebiet (160, 162), wobei das Kanalgebiet (130, 132) ein zweites Halbleitermaterial enthält; und
eine Gate-Struktur (184) über dem Kanalgebiet (130, 132); **dadurch gekennzeichnet, dass** die Pufferschicht (120) eine Ge-basierte Schicht ist, die eine Konzentration an Germanium enthält, die von der Grenzfläche der Pufferschicht (120) und des Substrats (110) schrittweise abnimmt.

2. Integrierte Schaltungsvorrichtung nach Anspruch 1, wobei:
die Pufferschicht (120) eine entspannte Gitterkonstante relativ zum Substrat (110) aufweist; und
das Kanalgebiet (130, 132) eine gespannte Gitterkonstante relativ zur Pufferschicht (120) aufweist.

3. Integrierte Schaltungsvorrichtung nach einem der Ansprüche 1-2, wobei:
das Kanalgebiet (130, 132) relativ zur Pufferschicht (120) unter Zugspannung steht.
das Kanalgebiet (130, 132) relativ zur Pufferschicht (120) unter Druckspannung steht.

4. Integrierte Schaltungsvorrichtung nach einem der Ansprüche 1-3, wobei:
das erste Halbleitermaterial ein erstes Halbleitermaterial der Gruppe IV umfasst; und
das zweite Halbleitermaterial ein zweites Halbleitermaterial der Gruppe IV umfasst.

5. Integrierte Schaltungsvorrichtung nach Anspruch 4, wobei:
das erste Halbleitermaterial der Gruppe IV Silicium und Germanium umfasst; und
das zweite Halbleitermaterial der Gruppe IV Silicium, Germanium oder Zinn umfasst.

6. Integrierte Schaltungsvorrichtung nach einem der Ansprüche 1-3, wobei das zweite Halbleitermaterial ein zweites Halbleitermaterial der Gruppe III-V umfasst.

7. Integrierte Schaltungsvorrichtung nach Anspruch 6, wobei das zweite Halbleitermaterial der Gruppe III-V Indium, Gallium, Aluminium, Arsen oder Antimon umfasst.

8. Integrierte Schaltungsvorrichtung nach einem der Ansprüche 1-7, wobei mindestens einige der mehreren Ionen (126) Kohlenstoff, Zinn, Bor, Phosphor oder Arsen umfassen.

9. Integrierte Schaltungsvorrichtung nach einem der Ansprüche 1-8, wobei die Pufferschicht (120) eine Dicke von mindestens 500 Nanometern aufweist.

10. Integrierte Schaltungsvorrichtung nach einem der Ansprüche 1-9, wobei das Kanalgebiet (130, 132) entweder n- oder p-dotiert ist und die Pufferschicht (120) relativ zum Kanalgebiet (130, 132) die jeweils andere Dotierung aufweist.

11. Integrierte Schaltungsvorrichtung nach einem der Ansprüche 1-10, die ferner Folgendes umfasst:
Verarbeitungsschaltungsanordnung;
Speicherschaltungsanordnung; und
Kommunikationsschaltungsanordnung;
wobei die Verarbeitungsschaltungsanordnung, die Speicherschaltungsanordnung oder die Kommunikationsschaltungsanordnung einen integrierten Schaltkreis-Die umfasst, wobei der integrierten Schaltkreis-Die das Substrat, die Pufferschicht, das Source-Gebiet, das Drain-Gebiet, das Kanalgebiet und die Gate-Struktur umfasst.

12. Integrierte Schaltungsvorrichtung nach einem der Ansprüche 1-11, wobei:
das Source-Gebiet (160, 162) mehrere Source-Gebiete umfasst;
das Drain-Gebiet (160, 162) mehrere Drain-Gebiete umfasst;
das Kanalgebiet (130, 132) mehrere Kanalgebiete umfasst; die Gate-Struktur (184) mehrere Gate-Strukturen umfasst; und
die integrierte Schaltungsvorrichtung ferner mehrere Transistoren oberhalb der Pufferschicht (120) umfasst, wobei einzelne Transistoren Folgendes umfassen:
ein entsprechendes Source-Gebiet aus den mehreren Source-Gebieten;
ein entsprechendes Drain-Gebiet aus den mehreren Drain-Gebieten;
ein entsprechendes Kanalgebiet aus den mehreren Kanalgebieten; und
eine entsprechende Gate-Struktur aus den mehreren Gate-Strukturen.

13. Integrierte Schaltungsvorrichtung nach Anspruch 12, die ferner eine komplementäre Metalloxidhalbleiter(CMOS)-Schaltung umfasst, wobei die CMOS-Schaltung die mehreren Transistoren umfasst und wobei die mehreren Transistoren Folgendes umfassen:
einen n-Kanal-Transistor, wobei der n-Kanal-Transistor eine Zugspannung in dem entsprechenden Kanalgebiet aufweist; und
einen p-Kanal-Transistor, wobei der p-Kanal-Transistor eine Druckspannung in dem entsprechenden Kanalgebiet aufweist.

14. Verfahren zum Bilden der integrierten Schaltungsvorrichtung nach einem der vorhergehenden Ansprüche.

## Revendications

1. Dispositif à circuit intégré, comprenant :
un substrat (110) comprenant du silicium ;
une couche tampon (120) au-dessus du substrat (110), la couche tampon (120) présentant une pluralité de défauts (124) à proximité d'une interface de la couche tampon (120) et du substrat (110), et la couche tampon (120) comprenant :
un premier matériau semi-conducteur ; et
une pluralité d'ions (126), la pluralité d'ions (126) étant implantée parmi la pluralité de défauts (124) ;
une région de source (160, 162) au-dessus de la couche tampon (120) ;
une région de drain (160, 162) au-dessus de la couche tampon (120) ;
une région de canal (130, 132) au-dessus de la couche tampon (120) et entre la région de source (160, 162) et la région de drain (160, 162), la région de canal (130, 132) comprenant un second matériau semi-conducteur ; et une structure de grille (184) au-dessus de la région de canal (130, 132) ;
**caractérisé en ce que** la couche tampon (120) est une couche à base de Ge comprenant une concentration en germanium décroissant par paliers à partir de l'interface de la couche tampon (120) et du substrat (110).

2. Dispositif à circuit intégré selon la revendication 1, dans lequel :
la couche tampon (120) présente une constante de réseau relaxée par rapport au substrat (110) ; et
la région de canal (130, 132) présente une constante de réseau contrainte par rapport à la couche tampon (120).

3. Dispositif à circuit intégré selon l'une quelconque des revendications 1 à 2, dans lequel :
la région de canal (130, 132) est contrainte en tension par rapport à la couche tampon (120) ; ou
la région de canal (130, 132) est contrainte en compression par rapport à la couche tampon (120).

4. Dispositif à circuit intégré selon l'une quelconque des revendications 1 à 3, dans lequel :
le premier matériau semi-conducteur comprend un premier matériau semi-conducteur du groupe IV ; et
le second matériau semi-conducteur comprend un second matériau semi-conducteur du groupe IV.

5. Dispositif à circuit intégré selon la revendication 4, dans lequel :
le premier matériau semi-conducteur du groupe IV comprend du silicium et du germanium ; et
le second matériau semi-conducteur du groupe IV comprend du silicium, du germanium ou de l'étain.

6. Dispositif à circuit intégré selon l'une quelconque des revendications 1 à 3, dans lequel le second matériau semi-conducteur comprend un second matériau semi-conducteur du groupe III-IV.

7. Dispositif à circuit intégré selon la revendication 6, dans lequel le second matériau semi-conducteur du groupe III-V comprend de l'indium, du gallium, de l'aluminium, de l'arsenic ou de l'antimoine.

8. Dispositif à circuit intégré selon l'une quelconque des revendications 1 à 7, dans lequel au moins certains de la pluralité d'ions (126) comprennent du carbone, de l'étain, du bore, du phosphore ou de l'arsenic.

9. Dispositif à circuit intégré selon l'une quelconque des revendications 1 à 8, dans lequel la couche tampon (120) a une épaisseur d'au moins 500 nanomètres.

10. Dispositif à circuit intégré selon l'une quelconque des revendications 1 à 9, dans lequel la région de canal (130, 132) est dopée de l'un du type n et du type p et la couche tampon (120) est dopée de l'autre du type n et du type p dopée par rapport à la région de canal (130, 132).

11. Dispositif à circuit intégré selon l'une quelconque des revendications 1 à 10, comprenant en outre :
des circuits de traitement ;
des circuits de mémoire ; et
des circuits de communication ;
dans lequel les circuits de traitement, les circuits de mémoire ou les circuits de communication comprennent une puce de circuit intégré, la puce de circuit intégré comprenant le substrat, la couche tampon, la région de source, la région de drain, la région de canal et la structure de grille.

12. Dispositif à circuit intégré selon l'une quelconque des revendications 1 à 11, dans lequel :
la région de source (160, 162) comprend une pluralité de régions de source ;
la région de drain (160, 162) comprend une pluralité de régions de drain ;
la région de canal (130, 132) comprend une pluralité de régions de canal ;
la structure de grille (184) comprend une pluralité de structures de grille ; et
le dispositif de circuit intégré comprend en outre une pluralité de transistors au-dessus de la couche tampon (120), les transistors individuels comprenant :
une région de source correspondante parmi la pluralité de régions de source ;
une région de drain correspondante parmi la pluralité de régions de drain ;
une région de canal correspondante parmi la pluralité de régions de canal ; et
une structure de grille correspondante parmi la pluralité de structures de grille.

13. Dispositif à circuit intégré selon la revendication 12, comprenant en outre un circuit semi-conducteur à oxyde métallique complémentaire, CMOS, le circuit CMOS comprenant la pluralité de transistors, et la pluralité de transistors comprenant :
un transistor à canal n, le transistor à canal n présentant une contrainte en tension dans la région de canal correspondante ; et
un transistor à canal p, le transistor à canal p présentant une contrainte en compression dans la région de canal correspondante.

14. Procédé de formation du dispositif à circuit intégré selon l'une quelconque des revendications précédentes.
